# EUROPEAN PATENT SPECIFICATION

(11) **EP 2 757 416 B1**
(45) Date of publication and mention of the grant of the patent: **27.04.2016**
(21) Application number: 12832381.3
(22) Date of filing: 29.08.2012
(51) Int. Cl.: G03F 7/11, G03F 7/00, G03F 7/004, G03F 7/32, B41C 1/10

(54) **PROCESS FOR PRODUCING LITHOGRAPHIC PRINTING PLATE AND LITHOGRAPHIC PRINTING PLATE**
VERFAHREN ZUR HERSTELLUNG EINER LITHOGRAPHIEDRUCKPLATTE UND LITHOGRAPHIEDRUCKPLATTE
PROCÉDÉ DE FABRICATION D'UNE PLAQUE D'IMPRESSION LITHOGRAPHIQUE ET PLAQUE D'IMPRESSION LITHOGRAPHIQUE

(30) Priority: 13.09.2011 JP 2011199948
(43) Date of publication of application: 23.07.2014
(73) Proprietor: Fujifilm Corporation, Minato-ku Tokyo 106-8620 (JP)
(72) Inventor: FUJII, Shigekatsu, Haibara-gun Shizuoka 421-0396 (JP); TAGUCHI, Yoshinori, Haibara-gun Shizuoka 421-0396 (JP); AOSHIMA, Norio, Haibara-gun Shizuoka 421-0396 (JP)
(74) Representative: Hoffmann Eitle
(86) International application number: PCT/JP2012/071893
(87) International publication number: WO 2013/038909

(56) References cited:
- EP-A1- 2 339 401
- JP-A- 2009 047 754
- JP-A- 2009 151 275
- JP-A- 2010 231 195
- JP-A- 2010 281 898

## Description

### TECHNICAL FIELD

The present invention relates to a method for producing a planographic printing plate using an infrared radiation-sensitive planographic printing plate precursor, and a planographic printing plate obtained by the production method.

### BACKGROUND ART

Various photosensitive compositions have hitherto been used as materials for forming a visible image or materials for forming a planographic printing plate. In particular, recent progress in lasers is outstanding in planographic printing, and especially, as solid state lasers and semiconductor lasers having an emission region from near infrared to infrared, lasers having a high output and of a small size have been more easily obtainable. These lasers are very useful as an exposure light source when plate-making is performed directly from digital data such as computers.

An infrared radiation-sensitive positive type planographic printing plate precursor, which is preferably used for recording using an infrared light laser, includes an alkali-soluble binder resin and an infrared absorber absorbing light and generating heat, as essential components. The infrared absorber acts as a development restrainer, which substantially reduces a solubility of the binder resin in a developer by an interaction with the binder resin in an unexposed area (image area), and an exposed area (non-image area) has reduced interaction between the infrared absorber and the binder resin due to generated heat and dissolves in the alkali developer, whereby a planographic printing plate is formed.

In such a positive type planographic printing plate material for infrared laser, however, sufficient difference in the solubility cannot be obtained between the unexposed area and the exposed area, and thus latitude in development conditions suitable for image-forming (development latitude) is insufficient. As a result, remaining films may be generated if development is performed using a fatigued developer with deteriorated activity, and strength of the image area is reduced and thus the printing durability may be reduced if the development is performed using a developer with high activity.

In order to improve the printing durability, techniques have been studied in which an intermediate layer or an undercoat layer is provided between a support and an image-forming layer for improving adhesion between them, and for example a positive type planographic printing plate precursor in which an undercoat layer including a compound with a betaine structure is provided (see, for example, Japanese patent Application Laid-Open (JP-A) No. 2009-47754) or a method for producing a planographic printing plate in which a positive type planographic printing plate precursor in which an undercoat layer including a compound having an adsorptive group such as a phosphonic acid or phosphoric acid group is provided is developed in a developer having a low pH (see, for example, JP-A No. 2009-222904) have been proposed.

EP-A-2 339 401 discloses a method for preparing a lithographic printing plate comprising image-wise exposing a lithographic printing plate precursor comprising, in the following order, a support, an intermediate layer containing a copolymer and an image-forming layer containing a polymerization initiator, a polymerizable compound and a binder polymer. Unexposed areas of the image-forming layer are removed by processing the exposed lithographic printing plate precursor with an aqueous solution having a buffer function.

The copolymer in the intermediate layer may be: 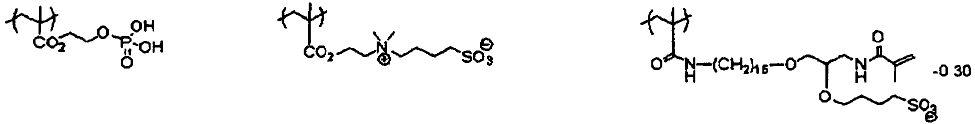 in respective molar ratios 40:50:10 and having a molecular weight of 12 x 10⁴, or 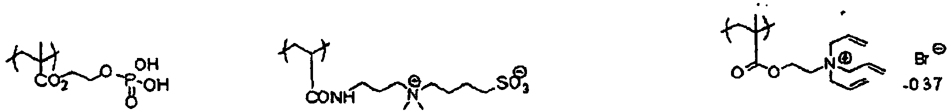 in respective molar ratios 45:45:10 and having a molecular weight of 7 x 10⁴.

### SUMMARY OF INVENTION

### TECHNICAL PROBLEM

The undercoat layer including the compound with the betaine structure, however, has high adhesion to components of the image-forming layer, and thus in order to inhibit stain in the non-image area caused by the reduced developability, an aqueous alkali solution having a high pH is used in the technique in JP-A No. 2009-47754, and thus the technique has a problem in which the image-forming layer is peeled off together with the undercoat layer in the image area, thus resulting in deteriorated image reproducibility. When the compound having the adsorptive group such as a phosphonic acid or phosphoric acid group is used, there is yet a room to improve each of the printing durability and the stain resistance.

In view of the problems described above, an object of the present invention is to provide a method for producing a planographic printing plate using a positive type planographic printing plate precursor, which is unlikely to cause the stain due to the reduced hydrophilicity in the non-image area, and provides excellent printing durability in the image area, and to provide a planographic printing plate obtained by the production method.

### SOLUTION TO PROBLEM

The above described problems are solved by the following means according to the invention.
<1> A method for producing a planographic printing plate, comprising the steps of:
   image-wise exposing a positive type planographic printing plate precursor including an intermediate layer and a positive type image-forming layer successively on a support, the intermediate layer having a coating amount after drying of from 2 mg/m² to 200 mg/m² and including a polymer including a repeating unit represented by the following formula (I-1) and a repeating unit represented by the following formula (1-2); and
   developing the exposed positive type planographic printing plate precursor by removing image-wise exposed areas using a treatment liquid having a pH of from 7 to 12:

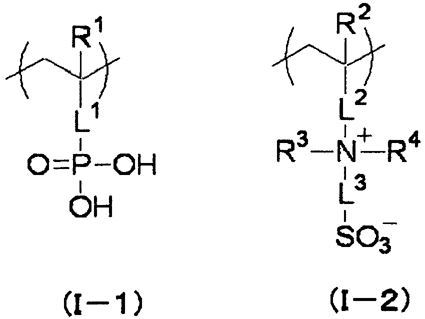

   wherein, in the formula (1-1), R¹ represents a hydrogen atom, a methyl group, or an ethyl group; L¹ represents a single bond or -COO-(CH₂CH₂O)ₙ-; and n represents an integer of from 1 to 12, and wherein, in the formula (1-2), R² represents a hydrogen atom, a methyl group, or an ethyl group; R³ and R⁴ each independently represent an alkyl group having 1 to 3 carbon atoms; L² represents a linking group selected from -COO-, -CONH-, or an alkylene group having 1 to 5 carbon atoms, or a linking group formed by connecting two or more of these; and L³ represents an alkylene group or -CH₂CHOHCH₂-.
<2> The method for producing a planographic printing plate according to <1>, wherein a molar content ratio of the repeating unit represented by the formula (I-1) to the repeating unit represented by the formula (I-2) in the polymer is in a range of from 5:95 to 50:50.
<3> The method for producing a planographic printing plate according to <1> or <2>, wherein the polymer further includes one or more repeating units each having a hydrophilic group and differing in structure from the repeating unit represented by the formula (I-1) and the repeating unit represented by the formula (I-2).
<4> The method for producing a planographic printing plate according to any one of <1> to <3>, wherein the positive type image-forming layer includes a water-insoluble and alkali-soluble polymer and an infrared absorber.
<5> The method for producing a planographic printing plate according to any one of <1> to <4>, wherein the treatment liquid is a buffer solution.
<6> The method for producing a planographic printing plate according to any one of <1> to <5>, wherein the treatment liquid includes a surfactant.
<7> The method for producing a planographic printing plate according to <6>, wherein a content ratio of the surfactant in the treatment liquid is from 0.2% by mass to 20% by mass.
<8> The method for producing a planographic printing plate according to <6> or <7>, wherein the surfactant is a betaine surfactant.
<9> A planographic printing plate which is obtained by the production method according to any one of <1> to <8>.

The mechanism of the present invention is not clarified, but it can be assumed as follows:
The positive type planographic printing plate precursor used in the production method of the present invention includes, in the intermediate layer, a polymer including a repeating unit represented by the formula (1-1), which has an adsorptive partial structure capable of improving the adhesion by adsorption to the support, and a repeating unit represented by the formula (I-2), which has a hydrophilic partial structure. As a result, in the unexposed area, the adhesion to the support is improved due to the adsorptive partial structure represented by the formula (1-1), and the adhesion to the image-forming layer is improved due to the ammonium cation partial structure represented by the formula (1-2), so that high printing durability can be exhibited, while, in the exposed area, the hydrophilicity can be maintained in the non-image area due to the adsorptive partial structure represented by the formula (I-1) and the hydrophilic partial structure represented by the formula (1-2).
The polymer included in the intermediate layer in the present invention, therefore, remains on the surface of the support even after the image-forming layer is removed, and the hydrophilic partial structure in the polymer improves the hydrophilicity of the surface of the support, thus resulting in high stain resistance. As a result, effects capable of inhibiting the generation of stain in the non-image area can be exhibited even after restarting the printing after the printing is interrupted or even after many sheets are printed. Reduction of maculature because of high receptivity of dampening water at the initial stage of printing and after restarting the printing after the printing is interrupted, which results from the high stain resistance, is also one of the effects of the method for producing a planographic printing plate using the positive type planographic printing plate precursor of the present invention.

In the specification, a numerical value range expressed by using "to" refers to a range including the numerical values described before and after "to" as the lower limit and the upper limit.

In the specification, an "alkyl group" refers to a "linear, branched or cyclic" alkyl group.

In the specification, a substituent (an atomic group) is used in the sense that both an unsubstituted substituent and a substituent further having a substituent are included. In the specification, accordingly, an "alkyl group" is used in the sense that both an unsubstituted alkyl group and a substituted alkyl group are included, and the same is applied to other substituents.

### ADVANTAGEOUS EFFECTS OF INVENTION

According to the invention, it is possible to provide a method for producing a planographic printing plate using a positive type planographic printing plate precursor, which is unlikely to cause the stain due to the reduced hydrophilicity in the non-image area, and provides excellent printing durability in the image area, and to provide a planographic printing plate obtained by the production method.

### DESCRIPTION OF EMBODIMENTS

### «Positive Type Planographic Printing Plate Precursor»

First, a positive type planographic printing plate precursor, which is applied to the production method of the present invention, will be explained. The positive type planographic printing plate precursor in the present invention (hereinafter which may be referred to simply as a "planographic printing plate precursor") includes an intermediate layer and a positive type image-forming layer successively on a support, the intermediate layer including a polymer including a repeating unit represented by the following formula (1-1) and a repeating unit represented by the following formula (I-2).

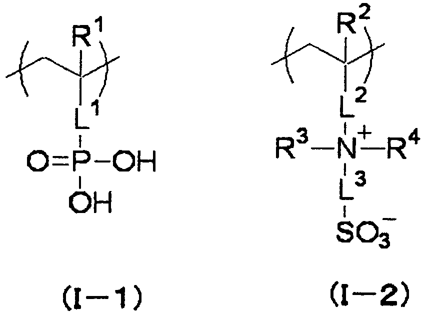

In the formula (I-1), R¹ represents a hydrogen atom, a methyl group, or an ethyl group; L¹ represents a single bond, or -COO-(CH₂CH₂O)ₙ-; and n represents an integer of 1 to 12.

In the formula (I-2), R² represents a hydrogen atom, a methyl group, or an ethyl group; R³ and R⁴ each independently represent an alkyl group having 1 to 3 carbon atoms; L² represents a linking group selected from -COO-, -CONH-, and an alkylene group having 1 to 5 carbon atoms, or a linking group formed by connecting two or more of these; and L³ represents an alkylene group or -CH₂CHOHCH₂-.

In the present invention, the phrase "include successively" means that the intermediate layer and the image-forming layer are disposed on the support in this order, and other layers may be further included. The planographic printing plate precursor in the present invention, accordingly, may further include, in addition to the image-forming layer, other optional layers such as a protective layer and a backcoat layer, so long as the effects of the present invention are not impaired. The image-forming layer may have a monolayer structure or a multilayer structure.

In the present invention, the term "alkali-soluble" means to be soluble in an aqueous alkali solution having a pH of 8.5 to 13.5 by a treatment in a standard developing time. The term "water-insoluble" means to be insoluble or not to be swollen in water having a pH of 6.0 to 8.0.

The planographic printing plate precursor in the present invention is widely sensitive to infrared lights for making a printing plate, and in particular it is a planographic printing plate precursor, which is suitable for infrared laser exposure and provides a positive image.

Compositions of the intermediate layer and the image-forming layer in the planographic printing plate precursor in the present invention, and components included in each layer will be successively explained below.

### <Intermediate Layer>

The intermediate layer in the planographic printing plate precursor in the present invention includes a polymer including a repeating unit represented by the formula (I-1) and a repeating unit represented by the formula (I-2). Hereinafter, the polymer may sometimes be referred to as a "specific polymer."

### (Repeating Unit Represented by Formula (I-1))

First, the repeating unit represented by the formula (I-1) will be explained.

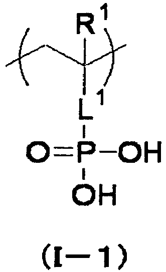

In the formula (1-1), R¹ represents a hydrogen atom, a methyl group, or an ethyl group; L¹ represents a single bond, or -COO-(CH₂CH₂O)ₙ-; and n represents an integer of 1 to 12.

The repeating unit represented by the formula (1-1) has, as apparent from the structure thereof, a hydrophilic partial structure. The hydrophilic partial structure is brought into contact with an excessive alkaline treatment liquid to exhibit high hydrophilicity, thereby improving the developability of the image-forming layer and contributing to the improvement in the hydrophilicity of the surface of the support.

In the formula (I-1), R¹ represents a hydrogen atom, a methyl group, or an ethyl group; L¹ represents a single bond, or -COO-(CH₂CH₂O)ₙ-; and n represents an integer of 1 to 12.

R¹ is preferably a hydrogen atom or a methyl group. L¹ is preferably -COO-(CH₂CH₂O)ₙ-. n represents preferably an integer of 1 to 10, more preferably 1 to 6.

Specific examples [(A-1) to (A-6)] of the repeating unit represented by the formula (I-1) are shown below, but the present invention is not limited to the specific examples.

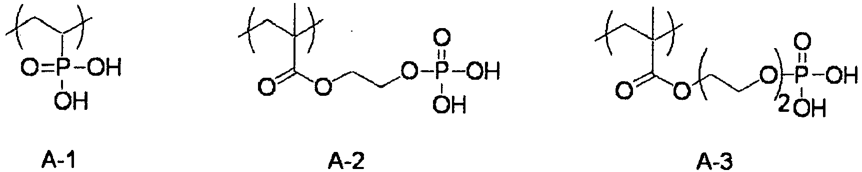

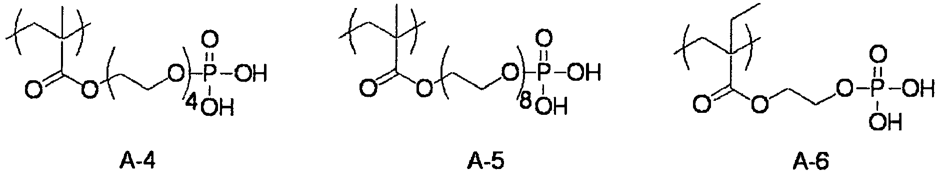

### (Repeating Unit Represented by Formula (I-2))

Next, the repeating unit represented by the formula (I-2) described below will be explained.

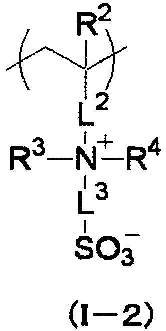

In the formula (1-2), R² represents a hydrogen atom, a methyl group, or an ethyl group; R³ and R⁴ each independently represent an alkyl group having 1 to 3 carbon atoms; L² represents a linking group selected from -COO-, -CONH-, and an alkylene group having 1 to 5 carbon atoms, or a linking group formed by connecting two or more of these; and L³ represents an alkylene group or -CH₂CHOHCH₂-.

The repeating unit represented by the formula (1-2) has, as apparent from the structure thereof, a betaine structure. The betaine structure acts as an adsorptive partial structure which improves the adhesion to the image-forming layer. The betaine structure also exhibits high hydrophilicity to contribute to the improvement of the hydrophilicity of the surface of the support.

R² is preferably a hydrogen atom or a methyl group, and more preferably a methyl group. R³ and R⁴ are preferably each independently a methyl group or an ethyl group, and more preferably a methyl group. R³ and R⁴ may be the same as or different from each other, and they are preferably the same as each other in view of the synthetic applicability.

L² represents a linking group selected from -COO-, -CONH-, and an alkylene group having 1 to 5 carbon atoms, or a linking group formed by connecting two or more of these, and a linking group formed by connecting two or more of these is preferable. Examples of L² may specifically include -COO-, -CONH-, -COO-CH₂CH₂-, -CONH-CH₂CH₂-, and -CONH-CH₂CH₂CH₂-, preferably-COO-, -CONH-, -COO-CH₂CH₂- and -CONH-CH₂CH₂-, more preferably -COO- and -CONH-.

L³ represents an alkylene group or -CH₂CHOHCH₂-, and as the alkylene group, an alkylene group having 1 to 5 carbon atoms is preferable, and -CH₂CH₂- and -CH₂CH₂CH₂- are more preferable.

Specific examples [(B-1) to (B-9)] of the repeating unit represented by the formula (I-2) are shown below, but the present invention is not limited to the specific examples.

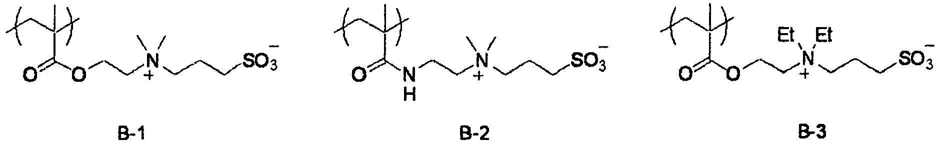

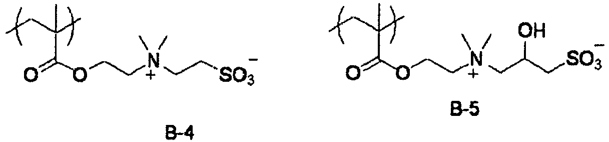

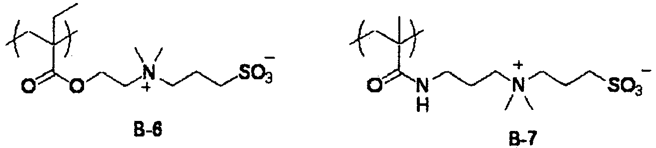

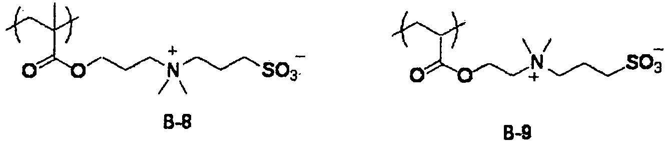

A molar content ratio of the repeating unit represented by the formula (I-1) to the repeating unit represented by the formula (I-2) in the specific polymer is in a range of preferably from 5:95 to 50:50, more preferably from 10:90 to 40:60.

The specific polymer in the present invention may further include, in addition to the repeating unit represented by the formula (I-1) and the repeating unit represented by the formula (1-2), a repeating unit (hereinafter which may arbitrarily referred to as "another repeating unit") which differs in structure from the repeating unit represented by the formula (I-1) and the repeating unit represented by the formula (I-2), for adjusting physical properties or adding various functions, in a range in which the effects of the present invention are not impaired. Preferable another repeating unit has a hydrophilic group.

The content ratio of another repeating unit is preferably 20% by mole or less in all the repeating units forming the specific polymer.

Specific examples [(C-1) to (C-4)] of another repeating unit which can be included in the specific polymer are shown below, but the present invention is not limited to the specific examples.

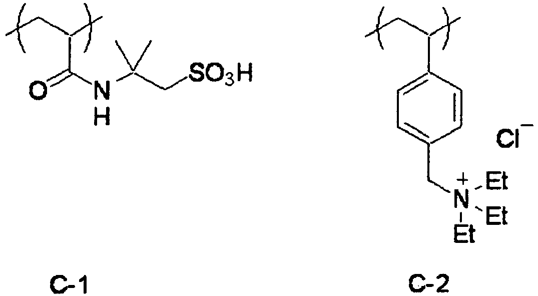

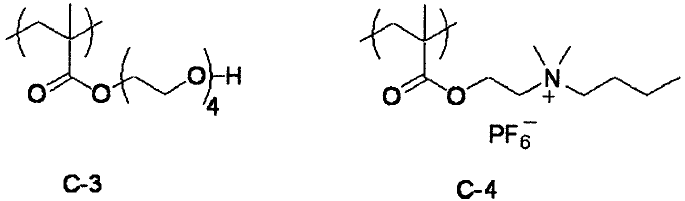

As each of the repeating unit represented by the formula (I-1), the repeating unit represented by the formula (1-2), and another optional repeating unit, one or two or more kinds of units may be included in the specific polymer.

Specific examples [(P-1) to (P-7)] of the specific polymer in the present invention are shown below with the repeating units included in the specific polymer, the polymerization molar ratio thereof, and the weight average molecular weight (Mw) of the polymer, but the present invention is not limited to the specific examples below.

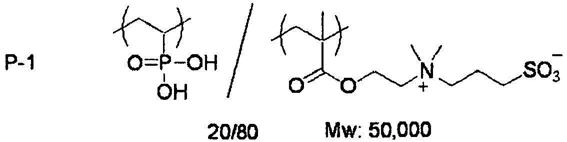

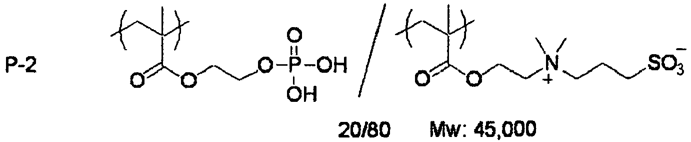

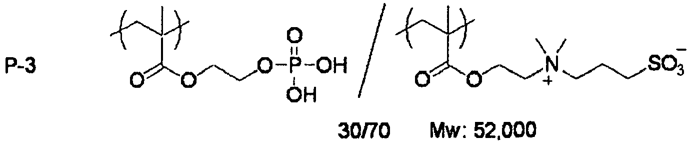

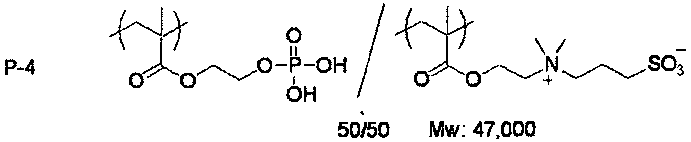

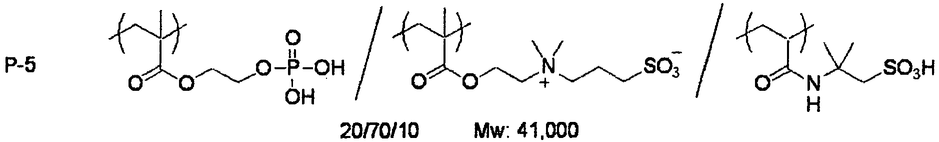

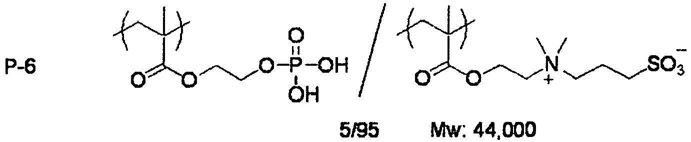

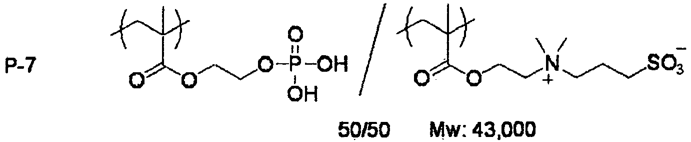

The intermediate layer is formed by dissolving the specific polymer in an appropriate solvent to prepare a coating liquid for the intermediate layer, coating the liquid on the support, and drying it.

The solvent used for preparing the coating liquid for the intermediate layer is not particularly limited so long as the solvent can uniformly dissolve the specific polymer. Examples of the solvent may include, for example, highly polar solvents such as water, alcohols such as methanol and ethanol, pyrrolidones such as N-methyl-2-pyrrolidone (NMP) and N-ethyl-2-pyrrolidone (NEP), N,N-dimethyl formamide (DMF), and dimethyl acetamide (DMAc), and methanol is preferable in terms of the solubility.

The coating liquid for the intermediate layer may include, in addition to the specific polymer and the solvent, another optional hydrophilic component within a range in which the effects of the present invention are not impaired.

A solid content concentration in the coating liquid for the intermediate layer is preferably within a range of 0.005% by mass to 10% by mass.

A coating amount after drying of the intermediate layer is within a range of preferably 2 mg/m² to 200 mg/m², more preferably 5 mg/m² to 100 mg/m², even more preferably 5 mg/m² to 50 mg/m².

When the coating amount is within the range described above, the effect of inhibiting the stain in the non-image area becomes excellent, and the high printing durability can be obtained.

### <Image-Forming Layer>

The image-forming layer in the planographic printing plate precursor used in the present invention is a positive type image-forming layer in which the solubility in the treatment liquid is increased by exposure.

The image-forming layer includes preferably a water-insoluble and alkali-soluble polymer and a compound which interacts with the water-insoluble and alkali-soluble polymer to reduce the alkali-solubility. Typical examples of such a compound may include infrared absorbers.

The image-forming layer may have a monolayer structure or a multilayer structure.

It is preferable that the image-forming layer includes at least (A) an infrared absorber and (B) a water-insoluble and alkali-soluble polymer from the viewpoint of the stability and the sensitivity, and is an interaction releasing type image-forming layer, in which the solubility in the developer is increased in the exposure area.

The image-forming layer may have a monolayer structure or a multilayer structure, and the multilayer structure is preferable in view of the development latitude, which is an indicator for the image formability.

In a case where the image-forming layer has the multilayer structure, a structure is preferable which is a multilayer structure including a lower layer including (C) an alkali-soluble polymer and an upper layer including (B) a water-insoluble and alkali-soluble polymer, wherein (A) an infrared absorber is included in at least one of the upper layer or the lower layer.

### ((A) Infrared absorber)

The infrared absorber included in the positive type image-forming layer in the planographic printing plate precursor is not particularly limited, and various dyes and pigments, which are known as an infrared absorber, may be appropriately selected and used.

The positive type image-forming layer includes preferably the infrared absorber. In a case where the image-forming layer has the multilayer structure, the infrared absorber may be included in either an upper layer or a lower layer, or in both of the upper layer and the lower layer.

As the infrared absorber in the present invention, known infrared absorbers may be used, and examples thereof may include dyes such as azo dyes, metal complex azo dyes, pyrazolone azo dyes, anthraquinone dyes, phthalocyanine dyes, carbonium dyes, quinone imine dyes, methine dyes, and cyanine dyes. In the present invention, dyes capable of absorbing infrared light or near infrared light among the dyes described above can be preferably used when recording is performed using a laser emitting infrared light or near infrared light.

The dyes which absorb the infrared light or near infrared light may include, for example, cyanine dyes described in JP-A Nos. S58-125246, S59-84356, S59-202829 and S60-78787, and the like; methine dyes described in JP-ANos. S58-173696, S58-181690 and S58-194595, and the like; naphthoquinone dyes described in JP-A Nos. S58-112793, S58-224793, S59-48187, S59-73996, S60-52940 and S60-63744, and the like; squarylium colorants described in JP-ANo. S58-112792, and the like; and cyanine dyes described in U.K. Patent No. 434,875, and the like.

As the dyes, which act as the infrared absorber, near infrared-absorbing sensitizers described in U.S. Patent No. 5,156,938 are also preferably used. In addition, examples may include substituted aryl benzo(thio)pyrylium salts described in U.S. Patent No. 3,881,924; trimethine thiapyrylium salts described in JP-A No. 57-142645 (U.S. Patent No. 4,327,169); pyrylium compounds described in JP-A Nos. S58-181051, S58-220143, S59-41363, S59-84248, S59-84249, S59-146063, and S59-146061; cyanine colorants described in JP-A No. S59-216146; pentamethine thiopyrylium salts described in U.S. Patent No. 4,283,475; and pyrylium compounds disclosed in Japanese Patent Application Publication (JP-B) Nos. H5-13514 and H5-19702. Particularly preferable commercially available infrared absorbers, which can be used in the present invention, may include EPOLIGHT III-178, EPOLIGHT III-130, and EPOLIGHT III-125, which are manufactured by Epolin Inc..

Other particularly preferable examples of the dye may include near infrared absorbing dyes represented by the formulae (I) and (II), described in the specification of U.S. Patent No. 4,756,993.

Of these dyes, particularly preferable examples may include the cyanine colorants, phthalocyanine dyes, oxonol dyes, squarylium colorants, pyrylium salts, thiopyrylium dyes, and nickel thiolate complexes. In addition, cyanine colorants represented by the following formula (a) are the most preferable, because in a case where it is used in the image-forming layer in the present invention, it can form a strong interaction with (B) the alkali-soluble polymer described below, and the light-heat converting ability, stability and economy are excellent.

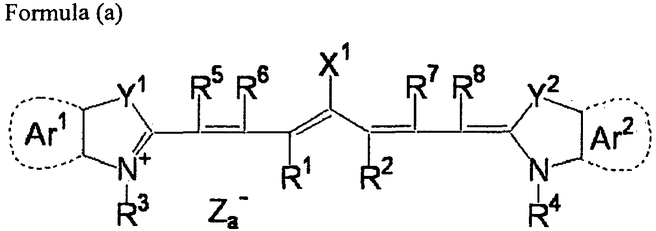

In the formula (a), X¹ represents a hydrogen atom, a halogen atom, -NPh₂, X²-L¹ or a group described below. X² represents an oxygen atom or a sulfur atom. L¹ represents a hydrocarbon group having 1 to 12 carbon atoms, an aromatic ring having a hetero atom, or a hydrocarbon group having a hetero atom and 1 to 12 carbon atoms. Here, the hetero atom shows an atom selected from N, S, O, a halogen atom, and Se.

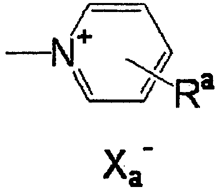

In the formula described above, Xa⁻ is defined in the same manner as Za⁻ described below, and R^{a} represents a substituent selected from a hydrogen atom, an alkyl group, an aryl group, a substituted or unsubstituted amino group, and a halogen atom.

R¹ and R² each independently represent a hydrocarbon group having 1 to 12 carbon atoms. R¹ and R² are preferably hydrocarbon groups having 2 or more carbon atoms for the storage stability of the coating liquid for the image-forming layer, and it is particularly preferable that R¹ and R² are bonded to each other to form a 5-membered or 6-membered ring.

Ar¹ and Ar² may be the same or different, and each represents an aromatic hydrocarbon group which may have a substituent. Preferable aromatic hydrocarbon groups may include a benzene ring and a naphthalene ring. Preferable substituents may include hydrocarbon groups having 12 or less carbon atoms, halogen atoms, and alkoxy groups having 12 or less carbon atoms.

Y¹ and Y² may be the same or different, and each represents a sulfur atom or a dialkyl methylene group having 12 or less carbon atoms. R³ and R⁴ may be the same or different, and each represents a hydrocarbon group having 20 or less carbon atoms, which may have a substituent. Preferable substituents may include alkoxy groups having 12 or less carbon atoms, carboxyl groups, and sulfo groups.

R⁵, R⁶, R⁷ and R⁸ may be the same or different, and each represents a hydrogen atom or a hydrocarbon group having 12 or less carbon atoms. The hydrogen atom is preferable because of easy availability of the starting material. Za⁻ represents a counter anion. In a case where the cyanine colorant represented by the formula (a) has an anionic substituent in its structure and thus it is not required to neutralize electric charges, however, Za⁻ is not required. Preferable Za⁻ is a halogen ion, a perchlorate ion, a tetrafluoroborate ion, a hexafluorophosphate ion, and a sulfonate ion such as an alkylsulfonate ion or an arylsulfonate ion, for the storage stability of the coating liquid for the image-forming layer, and the perchlorate ion, hexafluorophosphate ion, and arylsulfonate ion are particularly preferable.

Specific examples of the cyanine colorant represented by the formula (a), which can be preferably used, may include colorants described in paragraphs [0017] to [0019] of JP-A No. 2001-133969, paragraphs [0012] to [0038] of JP-A No. 2002-40638, and paragraphs [0012] to [0023] of JP-A No. 2002-23360.

As the infrared absorber included in the image-forming layer in the present invention, a cyanine dye described below is particularly preferable.

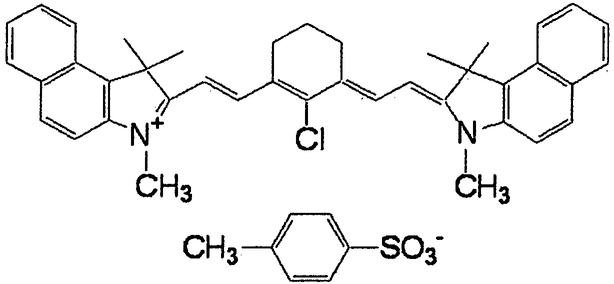

The sensitivity is increased when the image-forming layer includes the infrared absorber.

The addition amount of (A) the infrared absorber can be 0.01 to 50% by mass, preferably 0.1 to 30% by mass, and particularly preferably 1.0 to 30% by mass, with respect to the total solid content in the lower layer, from the viewpoint of the sensitivity, the uniformity and the durability of the image-forming layer.

### [(B) Water-Insoluble and Alkali-Soluble Polymer]

Examples of the water-insoluble and alkali-soluble polymer (hereinafter which may be arbitrarily referred to as an "alkali-soluble polymer") which can be used for the positive type image-forming layer include a homopolymer including an acidic group in the main chain and/or the side chain of the polymer, and copolymers and mixtures thereof.

Of these, a polymer having an acidic group listed in (1) to (6) described below in the main chain and/or the side chain of the polymer is preferable in terms of the solubility in an alkaline developer and the expression of dissolution inhibition ability.

(1) Phenol group (-Ar-OH)
(2) Sulfonamide group (-SO₂NH-R¹)
(3) Substituted sulfonamide acid group (hereinafter referred to as an "active imide group") [-SO₂NHCOR², -SO₂NHSO₂R², or -CONHSO₂R²]
(4) Carboxylic acid group (-CO₂H)
(5) Sulfonic acid group (-SO₃H)
(6) Phosphoric acid group (-OPO₃H₂)

In the above (1) to (6), Ar represents a divalent aryl linking group which may have a substituent; R¹ represents a hydrogen atom or a hydrocarbon group which may have a substituent; and R² represents a hydrocarbon group which may have a substituent.

Of the alkali-soluble polymers having an acidic group selected from the above (1) to (6), an alkali-soluble polymer having (1) the phenol group, (2) the sulfonamide group, or (3) the active imide group is preferable, and in particular an alkali-soluble polymer having (1) the phenol group or (2) the sulfonamide group is the most preferable, because the alkali-soluble polymer secures sufficiently the solubility in an alkaline developer, the development latitude, and the film strength.

As the alkali-soluble polymer having (1) the phenol group, which is preferably used in the present invention (hereinafter which may be referred to as a "phenol resin"), for example, alkali-soluble novolac resins are preferable. Examples of the alkali-soluble novolac resin may include, for example, alkali-soluble novolac resins such as phenol formaldehyde novolac resins, m-cresol formaldehyde novolac resins, p-cresol formaldehyde novolac resins, m-/p- mixed cresol formaldehyde novolac resins, mixed phenol/cresol (any of m-cresol, p-cresol, and m-/p- mixed cresol) formaldehyde novolac resins.

These alkali-soluble novolac resins preferably have a weight average molecular weight of 500 to 20000, and a number average molecular weight of 200 to 10000.

As described in U.S. Patent No. 4123279, as the phenol resin, a condensate of a phenol with an alkyl group having 3 to 8 carbon atoms as a substituent and formaldehyde, such as a t-butyl phenol formaldehyde novolac resin or an octyl phenol formaldehyde novolac resin, may be used.

### A resole resin may be used as the phenol resin included in the image-forming layer.

The resole resin used in the present invention is a resin obtained by condensation of a phenol with an aldehyde in basic conditions.

As the phenol, for example, phenol, m-cresol, p-cresol, o-cresol, bisphenol A, and the like are preferably used. The aldehyde described above may be, for example, formaldehyde. The phenol and the aldehyde may be used alone or as a mixture of two or more kinds.

In addition, a resole resin obtained from the mixture of the phenols described above and formaldehyde may be used. The degree of the condensation of the phenol and the formaldehyde, molecular weights, and a residual percentage of remaining monomers when the resole resin is obtained may be selected according to the objective.

Examples of the alkali-soluble polymer having (2) the sulfonamide group may include, for example, a polymer formed so as to have a minimum structural unit derived from a compound having a sulfonamide group as a main structural component. Examples of the compound described above may include a compound having one or more sulfonamide groups in which at least one hydrogen atom is bonded to a nitrogen atom and one or more polymerizable unsaturated groups in its molecule. Of these, a low molecular weight compound having an acryloyl group, an allyl group or a vinyloxy group, and a substituted or monosubstituted aminosulfonyl group or a substituted sulfonylimino group in its molecule is preferable, and examples thereof may include compounds represented by the following formulae (1) to (5).

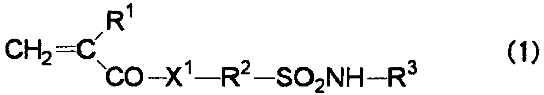

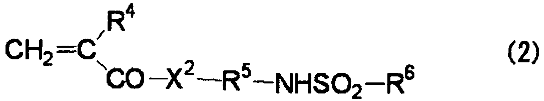

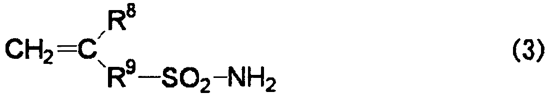

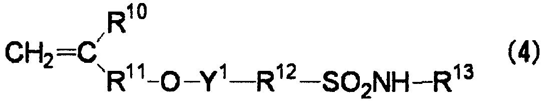

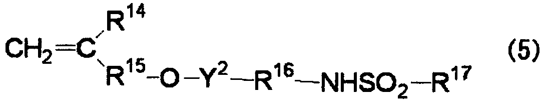

wherein X¹ and X² each independently represent -O- or NR⁷; R¹ and R⁴ each independently represent a hydrogen atom or -CH₃; R², R⁵, R⁹, R¹² and R¹⁶ each independently represent an alkylene group having 1 to 12 carbon atoms, a cycloalkylene group, an arylene group or an aralkylene group, which may have a substituent; R³, R⁷ and R¹³ each independently represent a hydrogen atom, or an alkyl group having 1 to 12 carbon atoms, a cycloalkyl group, an aryl group or an aralkyl group, which may have a substituent; R⁶ and R¹⁷ each independently represent an alkyl group having 1 to 12 carbon atoms, a cycloalkyl group, an aryl group or an aralkyl group, which may have a substituent; R⁸, R¹⁰ and R¹⁴ each independently represent a hydrogen atom or -CH₃; R¹¹ and R¹⁵ each independently represent a single bond, or an alkylene group having 1 to 12 carbon atoms, a cycloalkylene group, an arylene group or an aralkylene group, which may have a substituent; and Y¹ and Y² each independently represent a single bond or CO.

Of the compounds represented by the formulae (1) to (5), in particular m-aminosulfonylphenyl methacrylate, N-(p-aminosulfonylphenyl)methacrylamide, N-(p-aminosulfonylphenyl)acrylamide, and the like can be preferably used in the material for the positive type planographic printing in the present invention.

Examples of the alkali-soluble polymer having (3) the active imide group may include, for example, a polymer formed so as to have a minimum structural unit derived from a compound having an active imide group as a main structure component. Examples of the compound described above may include a compound having at least one active imide group represented by the following structural formula and at least one polymerizable unsaturated group in its molecule.

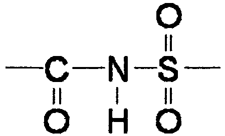

Specifically, N-(p-toluenesulfonyl)methacrylamide, N-(p-toluenesulfonyl)acrylamide, and the like can be preferably used.

As (B) the alkali-soluble polymer, (B-1) a water-insoluble and alkali-soluble polyurethane resin is also preferably used.

### ((B-1) Water-Insoluble and Alkali-Soluble Polyurethane Resin)

As the water-insoluble and alkali-soluble polyurethane resin, a resin having a carboxyl group in its polymer side chain is preferable, and examples thereof may include specifically a polyurethane resin including as a basic backbone a reaction product of a diisocyanate compound represented by the following formula (i) and a diol compound having a carboxyl group represented by the following formula (ii) or (iii).

OCN-R¹-NCO Formula (i)

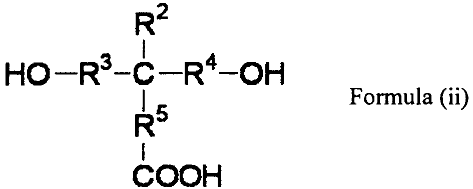

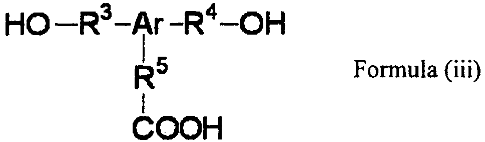

In formula (i), R¹ represents a divalent hydrocarbon group, examples of which may include preferably alkylene groups having 2 to 10 carbon atoms, and arylene groups having 6 to 30 carbon atoms. R¹ may include another functional group which is not reacted with an isocyanate group.

In the formula (ii), R² represents a hydrogen atom or a hydrocarbon group, examples of which may include preferably a hydrogen atom, unsubstituted alkyl groups having 1 to 8 carbon atoms, and unsubstituted aryl groups having 6 to 15 carbon atoms.

In the formula (ii) and the formula (iii), R³, R⁴ and R⁵ each independently represent a single bond or a divalent linking group. Examples of the divalent linking group may include, for example, aliphatic hydrocarbon groups and aromatic hydrocarbon groups, preferably unsubstituted alkylene groups having 1 to 20 carbon atoms and unsubstituted arylene groups having 6 to 15 carbon atoms, more preferably unsubstituted alkylene groups having 1 to 8 carbon atoms.

In the formula (iii), Ar represents a trivalent aromatic hydrocarbon, and an arylene group having 6 to 15 carbon atoms is preferable.

R¹ to R⁵ and Ar each may have a substituent which is not reacted with an isocyanate group.

Specific examples of the diisocyanate compound represented by the formula (i) may include the following compounds, but it is not limited to these compounds.

Examples may include aromatic diisocyanate compounds such as 2,4-tolylene diisocyanate, dimer of 2,4-tolylene diisocyanate, 2,6-tolylene diisocyanate, p-xylylene diisocyanate, metaxylylene diisocyanate, 4,4'-diphenylmethane diisocyanate, 1,5-naphthylene diisocyanate, and 3,3'-dimethylbiphenyl-4,4'-diisocyanate; aliphatic diisocyanate compounds such as hexamethylene diisocyanate, trimethylhexamethylene diisocyanate, lysine diisocyanate, and dimer acid diisocyanate; alicyclic diisocyanate compounds such as isophorone diisocyanate, 4,4'-methylenebis(cyclohexylisocyanate), methylcyclohexane-2,4 (or -2,6)-diisocyanate, and 1,3-(isocyanatemethyl)cyclohexane; and diisocyanate compounds which are reaction products of a diol and a diisocyanate, such as an adduct of one mole of 1,3-butylene glycol and two moles of tolylene diisocyanate.

Of these, compounds having an aromatic ring such as 4,4'-diphenylmethane diisocyanate, xylylene diisocyanate and tolylene diisocyanate are preferable in terms of the printing durability.

Examples of the diol compound having the carboxyl group represented by the formula (ii) or the formula (iii) may include specifically the following compounds, but the diol compound is not limited thereto.

Examples may include 3,5-dihydroxybenzoic acid, 2,2-bis(hydroxymethyl)propionic acid, 2,2-bis(hydroxyethyl)propionic acid, 2,2-bis(3-hydroxypropyl)propionic acid, 2,2-bis(hydroxymethyl)acetic acid, bis-(4-hydroxyphenyl)acetic acid, 4,4-bis-(4-hydroxyphenyl)pentanoic acid, and tartaric acid.

Of these, 2,2-bis(hydroxymethyl)propionic acid and 2,2-bis(hydroxyethyl)propionic acid are preferable in terms of the reactivity with the isocyanate.

It is desirable to use a diol compound represented by the following formula (iv) as the diol compound used for obtaining the water-insoluble and alkali-soluble polyurethane resin in the present invention, from the viewpoint of increasing the solubility of the image-forming layer in the developer and the permeability of the developer in the image-forming layer.

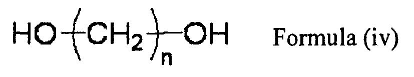

In the formula (iv), n represents an integer of 4 to 12, preferably an integer of 6 to 10.

The polyurethane resin in the present invention can be synthesized by adding to the diisocyanate compound and the diol compound a known catalyst having an activity corresponding to each reactivity of the compounds in an aprotic solvent, and heating the mixture.

A molar ratio of the diisocyanate used to the diol compound used is preferably from 0.8:1 to 1.2:1, and in a case where the isocyanate groups remain on the polymer ends, the remaining groups are treated with an alcohol or an amine, whereby the resin having no remaining isocyanate group can be finally synthesized.

The water-insoluble and alkali-soluble polyurethane resin in the present invention has a weight average molecular weight of preferably 1,000 or more, more preferably 5,000 to 100000. These polyurethane resins may be used as a mixture of two or more kinds.

The positive type image-forming layer may include one or two or more kinds of (B) the water-insoluble and alkali-soluble polymers.

The content ratio of (B) the water-insoluble and alkali-soluble polymer is preferably 30% by mass to 98% by mass, and more preferably 40% by mass to 95% by mass, in the total solid content of the positive type image-forming layer. The excellent durability, sensitivity, and image formability of the image-forming layer can be maintained in the content ratio range described above.

Here, the "solid content" refers to a total amount of components excluding the solvents of the entire composition for forming the image-forming layer.

### (C) Alkali-Soluble Polymer

The positive type image-forming layer may include an alkali-soluble polymer having water-solubility. The alkali-soluble polymer is not particularly limited so long as the alkali-soluble polymer is dissolved in an alkaline aqueous solution, and the resins which are listed above as (B) the water-insoluble and alkali-soluble polymer, and water-soluble and alkali-soluble resins can be used.

### ((C-1) Alkali-Soluble Acrylic Resin)

As the alkali-soluble polymer, alkali-soluble acrylic resins may be used.

Examples of the preferable alkali-soluble acrylic resin may include resins having the acidic group as described above in the main chain or side chain of the polymer. Such a resin can be obtained, for example, by polymerization of a monomer mixture including one or more ethylenically unsaturated monomers having an acidic group. Examples of the ethylenically unsaturated monomer having an acidic group, which is useful for forming the alkali-soluble polymer, may include monomers represented by the following formulae, in addition to acrylic acid and methacrylic acid. These ethylenically unsaturated monomers having the acidic group may be used alone or as a mixture of two or more kinds.

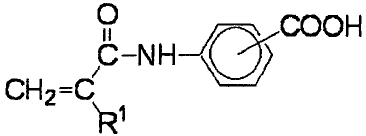

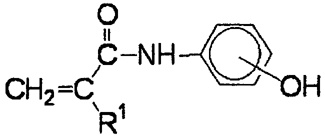

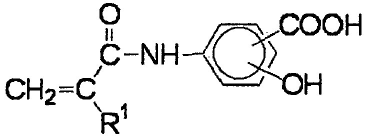

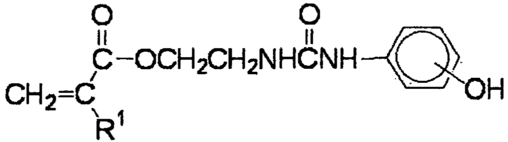

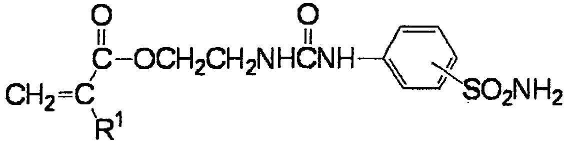

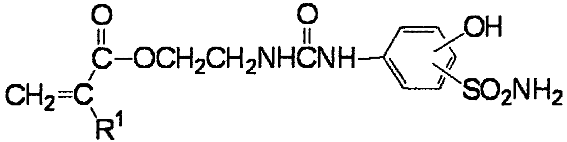

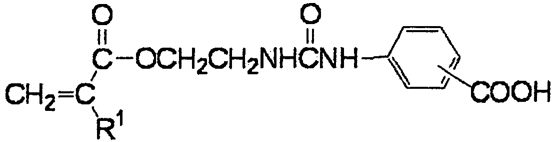

In each formula described above, each R¹ independently represents a hydrogen atom or a methyl group.

As the alkali-soluble acrylic resin, a high molecular weight compound obtained by copolymerization of an ethylenically unsaturated monomer having the acidic group described above (polymerizable monomer) with another polymerizable monomer are preferable. The copolymerization ratio of this case is such that the polymerizable monomer having the acidic group capable of providing the alkali-solubility is included in an amount of preferably 10% by mole or more, and more preferably from 20% by mole to 80% by mole, in terms of the developability of the image-forming layer.

### (C-1) Phenol Resin

In addition, as (C) the alkali-soluble polymer, the phenol resins, which have been explained above in the item (B) Water-Insoluble and Alkali-Soluble Polymer, may also be useful.

The alkali-soluble polymer has preferably a weight average molecular weight of 2,000 or more, and a number average molecular weight of 500 or more. More preferably, the alkali-soluble polymer has a weight average molecular weight of 5,000 to 300,000, a number average molecular weight of 800 to 250,000, and a degree of dispersion (a weight average molecular weight/a number average molecular weight) of 1.1 to 10.

As the weight average molecular weight of the alkali-soluble polymer, a value is used which is obtained by GPC (gel permeation chromatography) in terms of molecular weights of standard polystyrenes. As weight average molecular weights of the other high molecular weight compounds in the specification, values obtained in the same manner as above are used.

In a case where the image-forming layer has the multilayer structure, the layer has preferably a lower layer having excellent alkali-solubility and an upper layer having excellent image formability. From this viewpoint, the layer has preferably a multilayer structure including the lower layer including (C) the alkali-soluble polymer and the upper layer including (B) the water-insoluble and alkali-soluble polymer, wherein (A) the infrared absorber is included in at least one layer of the upper layer or the lower layer, and more preferably (A) the infrared absorber is included in the upper layer.

Another preferable embodiment may include a multilayer structure in which the lower layer includes (A) the infrared absorber, (C-1) the alkali-soluble acrylic resin, and (C-2) the phenol resin, and the upper layer includes (B-1) the water-insoluble and alkali-soluble polyurethane resin.

At this time, a content ratio of (C-1) the alkali-soluble acrylic resin is preferably from 20% by mass to 98% by mass, and more preferably from 30% by mass to 95% by mass, in the total solid content in the lower layer from the viewpoint of satisfying both the sensitivity and the durability of the image-forming layer. In addition, a content ratio of (C-2) the phenol resin is preferably from 2% by mass to 80% by mass, and more preferably from 5% by mass to 75% by mass, in the total solid content in the lower layer.

In a case where the resole resin is used as the phenol resin, the content ratio thereof is preferably from 2% by mass to 80% by mass, more preferably from 5% by mass to 75% by mass, and particularly preferably from 10% by mass to 70% by mass, in the total solid content in the lower layer in terms of the durability and the storage stability of the image-forming layer.

A content ratio of (C-1) the alkali-soluble acrylic resin to (C-2) the phenol resin in the lower layer (C-1:C-2) is preferably from 98:2 to 20:80 by mass, more preferably from 95:5 to 25:75, even more preferably from 90:10 to 30:70.

A content ratio of (B-1) the water-insoluble and alkali-soluble polyurethane resin included in the upper layer is preferably from 2% by mass to 99.5% by mass, more preferably from 5% by mass to 99% by mass, and particularly preferably from 10% by mass to 98% by mass, in the total solid content in the upper layer.

### [Other Additive]

In the formation of the image-forming layer, or the lower layer and the upper layer in a case of the multilayer structure, in addition to the essential components described above, various additives may be added if necessary, so long as the effects of the present invention are not impaired. The following additives may be added to only the lower layer or only the upper layer, or to both the layers. Examples of the additives may include a development accelerator, a surfactant, a printing-out agent/coloring agent, a plasticizer, and a wax agent, but they are not limited thereto.

### <Formation of Image-Forming Layer>

The image-forming layer in the planographic printing plate precursor in the present invention can be usually formed by dissolving the components described above in a solvent, and applying the resulting solution to the surface of the intermediate layer in the present invention which is formed on the support.

Examples of the solvent used here may include, but not limited to, ethylene dichloride, cyclohexanone, methyl ethyl ketone, methanol, ethanol, propanol, ethyleneglycol monomethyl ether, 1-methoxy-2-propanol, 2-methoxyethyl acetate, 1-methoxy-2-propyl acetate, dimethoxyethane, methyl lactate, ethyl lactate, N,N-dimethyl acetamide, N,N-dimethyl formamide, tetramethyl urea, N-methylpyrrolidone, N-ethylpyrrolidone, dimethyl sulfoxide, sulfolane, γ-butyrolactone, and toluene. These solvents may be used alone or as a mixture.

In a case where the image-forming layer has the multilayer structure, it is preferable that the lower layer and the upper layer are separately formed in principle.

Examples of the method for separately forming the two layers may include, for example, a method utilizing the difference in solvent solubility between the components included in the lower layer and the components included in the upper layer; and a method in which after the application of the upper layer, the solvent is quickly dried to remove it.

These methods will be explained in detail below, but the method for separate application of the two layers is not limited thereto.

The method utilizing the difference in solvent solubility between the components included in the lower layer and the components included in the upper layer is a method in which a solvent which does not dissolve all of the components included in the lower layer is used when the coating liquid for the upper layer is applied. According to this method, a coating film in which the layers are clearly separated from each other can be obtained even if a two-layer application is performed. For example, as the lower layer components, components insoluble in a solvent, such as methyl ethyl ketone or 1-methoxy-2-propanol, which dissolves the alkali-soluble polymer, which is the upper layer component, is selected, and the application and drying of the lower layer is performed using a solvent which dissolves the lower layer components. After that, dissolution in methyl ethyl ketone or 1-methoxy-2-propanol, applying and drying of the upper layer including mainly the alkali-soluble polymer is performed, whereby the two-layer structure can be obtained.

Next, the method in which after the application of the second layer (the upper layer), the solvent is extremely quickly dried can be attained by blowing high pressure air from a slit nozzle disposed at almost a right angle to a running direction of a web, applying heat energy as conductive heat by a roll having supplied heating medium such as steam in its inside (a heating roll) from the lower surface of a web, or combining them.

In order to provide a new function, partial compatibilization between the upper layer and the lower layer may sometimes be positively performed within a range in which the effects of the present invention can be sufficiently exhibited. This can be realized by adjusting the degree in either the method utilizing the difference in solvent solubility or the method in which the solvent is extremely quickly dried after the application of the second layer.

A concentration of the components excluding the solvents (the total solid content including the additives) in the coating liquid for the image-forming layer (including the coating liquids for the lower layer/the upper layer) to be applied on the support is preferably from 1% by mass to 50% by mass.

Various methods can be used for the application, and examples thereof may include, for example, a bar-coater application, spin coating, spray coating, curtain coating, dip coating, air-knife coating, blade coating, and roll coating.

In particular, for preventing the damage of the lower layer in the upper layer application, non-contact type application is preferable for the upper layer application method. In addition, it is possible to use bar-coater application, which is contact type application and is a method generally used for solvent type application, but it is preferable to perform the application by normal rotation driving for preventing the damage of the lower layer.

A coating amount after drying of the image-forming layer in the planographic printing plate precursor in the present invention is preferably within a range of 0.6 g/m² to 4.0g/m², more preferably 0.7 g/m² to 2.5g/m². In the range described above, the image-forming layer has excellent printing durability, image reproducibility and sensitivity. In a case where the image-forming layer has the multilayer structure, it is preferable that the total coating amount of the upper layer/the lower layer is within the range described above.

In a case where the image-forming layer has the multilayer structure, a coating amount after drying of the lower layer component to be coated on the support is preferably within a range of 0.5 g/m² to 4.0 g/m², more preferably 0.6 g/m² to 2.5 g/m². In the range described above, the obtained image-forming layer has excellent printing durability, image reproducibility and sensitivity.

A coating amount after drying of the upper layer component is preferably within a range of 0.05 g/m² to 1.0 g/m², more preferably 0.08 g/m² to 0.7 g/m². In the range described above, the image-forming layer has excellent development latitude, scratch resistance and recording sensitivity.

### <Support>

The support used in the planographic printing plate precursor in the present invention is not particularly limited so long as it is a planar object having necessary strength and durability and dimensional stability, and is arbitrarily selected, according to the purpose, from, for example, paper, paper laminated with a plastic (for example, polyethylene, polypropylene, polystyrene, or the like), metal plates (for example, aluminum, zinc, copper, and the like), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, and the like), and paper or a plastic film laminated or vapor-deposited with the above-described metal.

Of these, as the support applied to the planographic printing plate precursor, a polyester film or an aluminum plate is preferable, and the aluminum plate is particularly preferable because of the good dimensional stability and comparatively low cost. The preferable aluminum plates are a pure aluminum plate and an alloy plate including aluminum as a main component and a slight amount of different elements. The plastic films laminated or vapor-deposited with aluminum may also be used. Examples of the different elements included in the aluminum alloy may include silicon, iron, manganese, copper, magnesium, chromium, zinc, bismuth, nickel, and titanium. The alloy has a different element content ratio of preferably 10% by mass or less.

In the present invention, the particularly preferable aluminum is pure aluminum, but the aluminum including a slight amount of different elements may be used, because it is difficult to produce completely pure aluminum in a refining technology.

The composition of such an aluminum plate applied to the present invention is not specified, and conventionally known and used aluminum plates can be arbitrarily utilized. The aluminum plate used in the present invention has a thickness of preferably 0.1 mm to 0.6 mm, more preferably 0.15 mm to 0.4 mm, particularly preferably 0.2 mm to 0.3 mm.

Such an aluminum plate may optionally be subjected to a surface treatment such as a roughening treatment or an anodic oxidation treatment. The surface of the aluminum support is arbitrarily subjected to, for example, a delipidation treatment using a surfactant, an organic solvent or an alkaline aqueous solution, the surface roughening treatment, the anodic oxidation treatment, or the like, as described in detail in, for example, paragraphs [0167] to [0169] of JP-A No. 2009-175195.

The aluminum surface, which has been subjected to the anodic oxidation treatment, is subjected to a hydrophilization treatment if necessary.

For the hydrophilization treatment, an alkali metal silicate (for example, an aqueous sodium silicate solution) method, or a treating method using potassium zirconate fluoride or polyvinyl phosphonic acid is used as described in paragraph [0169] of JP-A No. 2009-175195.

### <Back Coat Layer>

A back coat layer is provided on the back surface of the support in the planographic printing plate precursor in the present invention, if necessary. As the back coat layer, a coating layer including an organic high molecular weight compound described in JP-A No. H5-45885, or a metal oxide obtained by hydrolysis and polycondensation of an organic or inorganic metal compound described in JP-A No. H6-35174 is preferably used. Of these coating layers, a coating layer of a metal oxide obtained from a silicon alkoxy compound such as Si(OCH₃)₄, Si(OC₂H₅)₄, Si(OC₃H₇)₄ or Si(OC₄H₉)₄, which are inexpensive and easily available, is particularly preferable because of the excellent developer resistance.

The produced planographic printing plate precursor as above is image-wise exposed, and then the developing treatment is performed.

### «Method for Producing Planographic Printing Plate»

The method for producing a planographic printing plate of the present invention has a step of image-wise exposing the positive type planographic printing plate precursor in the present invention; and a step of developing the exposed planographic printing plate precursor using a treatment liquid having a pH of 7 to 12.

When a planographic printing plate is produced by the production method of the present invention, the resulting planographic printing plate of the present invention has a non-image area in which stains are unlikely to be generated, and has an image area having high strength and printing durability.

As the treatment liquid, a buffer solution is preferable, and the buffer solution preferably includes a surfactant.

The content ratio of the surfactant in the treatment liquid is preferably 0.2% by mass to 20% by mass, and a betaine surfactant is preferable as the surfactant.

### <Exposure Step>

The method for producing a planographic printing plate of the present invention includes the exposure step in which the infrared radiation-sensitive positive type planographic printing plate precursor in the present invention is image-wise exposed.

A light source of active light used in the image exposure of the planographic printing plate precursor in the present invention is preferably a light source having emission wavelengths in a range of near infrared to infrared, and more preferably a solid state laser and a semiconductor laser. Of these, in the present invention, it is particularly preferable that the image exposure is performed using a solid state laser or a semiconductor laser emitting infrared light with a wavelength of 750 nm to 1,400 nm.

The laser has an output of preferably 100 mW or more, and it is preferable to use a multi-beam laser device for shortening the exposure time. It is also preferable that the exposure time per pixel is within 20 µ seconds.

An energy applied to the planographic printing plate precursor is preferably from 10 mJ/cm² to 300 mJ/cm².

The exposure in the present invention may be performed using a light beam from the light source in an overlapping state. The term "overlapping" means that a vertical scanning pitch width is smaller than a beam diameter. The overlapping can be quantitatively expressed, for example, by FWHM/vertical scanning pitch width (an overlapping coefficient) when the beam diameter is represented by a full width at half maximum (FWHM) of a beam intensity. In the present invention, the overlapping coefficient is preferably 0.1 or more.

The scanning manner of the light source of the exposure device, which can be used in the present invention, is not particularly limited, and cylinder outside-surface scanning, cylinder inside-surface scanning, flat-surface scanning or the like may be used. The light source may be mono-channel or multi-channel. In the case of the cylinder outside-surface scanning, it is preferably multi-channel.

### <Development Step>

The method for producing the planographic printing plate of the present invention includes the developing step in which the exposed planographic printing plate precursor is developed using the treatment liquid having a pH of 7 to 12.

### (The treatment liquid having pH of 7 to 12)

The treatment liquid having a pH of 7 to 12 used in the development step (hereinafter which may be sometimes referred to as a "treatment liquid") will be explained in detail below.

It is essential that the treatment liquid in the present invention has a pH of 7 to 12, and the liquid has a pH of, more preferably, 7 to 11. In a case where the treatment liquid has a pH of less than 7, the stain is easily generated in the non-image area due to the defective development, and in a case where the pH is more than 12, the intermediate layer may possibly be eliminated in the development step, and the stain resistance and the printing durability are deteriorated in the non-image area, and thus the both cases are not preferable.

The alkali agent which is used for adjusting the pH of the treatment liquid to the range described above is not particularly limited. As stated in detail below, it is preferable to use a buffer solution, and it is more preferable to use a carbonate buffer solution.

The treatment liquid includes preferably a surfactant. The surfactant is preferably at least one surfactant selected from amphoteric surfactants and anionic surfactants. Of these, betaine amphoteric surfactants are more preferable. The surfactant contributes to the improvement of the developing property.

### (Surfactant)

The amphoteric surfactants and anionic surfactants, which are preferably used in the treatment liquid, will be explained.

### (Amphoteric Surfactant)

Examples of the amphoteric surfactant, which is preferably used in the treatment liquid, may include compounds selected from compounds represented by the following formula (A) to the formula (C).

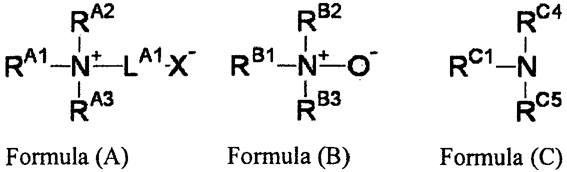

R^{A1}, R^{B1}, and R^{C1} each independently represent a monovalent substituent including an alkyl group with 6 to 24 carbon atoms. Examples of the monovalent substituent may include an alkyl group; an alkyl group bonded to a nitrogen atom through an amido bond or a carbonyl bond; and an alkyl group having an amido bond or a carbonyl bond in a carbon chain forming the alkyl group. The alkyl group included in the monovalent substituent is preferably a linear alkyl group having 8 to 18 carbon atoms. More preferable R^{A1}, R^{B1}, and R^{C1} may include an alkyl group having 8 to 18 carbon atoms, and an alkyl group having 8 to 18 carbon atoms and bonded to an amido bond.

R^{A2}, R^{B2}, R^{A3}, and R^{B3} each independently represent an alkyl group having 1 to 5 carbon atoms. Of these, a methyl group, ethyl group, and 2-hydroxyethyl group are preferable.

R^{C4} and R^{C5} each independently represent an alkyl group having 1 to 5 carbon atoms which has an acidic group or a salt thereof at the end. The acidic group or a salt thereof at the end is preferably a carboxy group or a salt thereof. Specifically, for example, a 2-carboxymethyl group, a 2-carboxyethyl group, a 2-carboxypropyl group, a carboxypolyethyleneoxide group, and carboxypolypropyleneoxide group are preferable.

L^{A1} represents a bivalent linking group having 1 to 4 carbon atoms. Of these, a methylene group, ethylene group, and propylene group are preferable.

X- represents an anionic group, and may have a salt structure. Specifically, X-represents a carboxylate ion or a salt thereof, a sulfonate ion or a salt thereof, a sulfate ion, a phosphonate ion or a salt thereof, or a phosphate ion or a salt thereof.

In a case where the anionic group has a salt structure, examples of a counter ion thereof may include a sodium ion, potassium ion, magnesium ion, and calcium ion.

Examples of the amphoteric surfactant preferably used in the treatment liquid may include specifically alkyl di(aminoethyl)glycine, an alkyl polyaminoethyl glycine hydrochloride, 2-alkyl-N-carboxyethyl-N-hydroxyethylimidazolinium betaine, and N-tetradecyl-N,N-betaine, and surfactants having a betaine structure are particularly preferable.

Specific examples of the amphoteric surfactant represented by the formula (A) may include LEVON 2000 and LEVON LD36 (manufactured by Sanyo Chemical Industries, Ltd.); TEXNOL R2 (manufactured by Nippon Nyukazai Co., Ltd);AM-301 and AM-3130N (manufactured by Nikko Chemicals Co., Ltd.); AMPHITOL 20AB, AMPHITOL 20BS, AMPHITOL 24B, AMPHITOL 55AB, and AMPHITOL 86B (manufactured by Kao Corporation); ADEKA AMPHOTE AB-35L and ADEKA AMPHOTE PB-30L (manufactured by Adeka Corporation); AMPHOREX CB-1 and AMPHOREX LB-2(manufactured by Miyoshi Oil & Fat Co., Ltd.); ENAGICOL C-30B and ENAGICOL L-30B(manufactured by Lion Corporation); OBAZOLINE BC, OBAZOLINE CAB-30, OBAZOLINE LB-SF, and OBAZOLINE LB (manufactured by Toho Chemical Industry Co., Ltd.); SOFTAZOLINE CPB-R, SOFTAZOLINE CPB, SOFTAZOLINE LPB-R, SOFTAZOLINE LPB, SOFTAZOLINE MPB, and SOFTAZOLINE PKBP (manufactured by Kawaken Fine Chemicals Co., Ltd.); and NISSAN ANON BDC-S, NISSAN ANON BDF-R, NISSAN ANON BDF-SF, NISSAN ANON BF, NISSAN ANON BL-SF, and NISSAN ANON BL (manufactured by NOF Corporation).

Specific examples of the amphoteric surfactant represented by the formula (B) may include AMPHITOL 20N (manufactured by Kao Corporation); SOFTAZOLINE LAO-C and SOFTAZOLINE LAO (manufactured by Kawaken Fine Chemicals Co., Ltd.); UNISAFE A-OM (manufactured by NOF Corporation); CATINAL AOC (manufactured by Toho Chemical Industry Co., Ltd.); and AROMOX DMC-W (manufactured by Lion Corporation).

Specific examples of the amphoteric surfactant represented by the formula (C) may include ENAGICOL DP-30 (manufactured by Lion Corporation), DERIPHAT 160C (manufactured by Cognis Japan Ltd.), and PIONIN C 158G (manufactured by Takemoto Oil & Fat Co., Ltd.).

Further specific examples of the amphoteric surfactant described above are exemplified by the following chemical structural formulae.

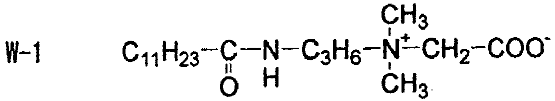

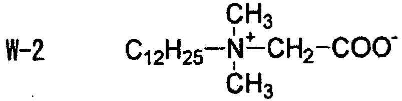

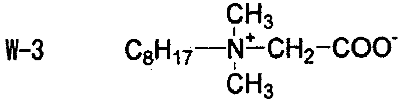

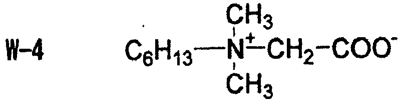

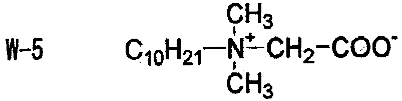

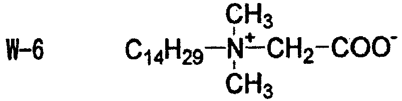

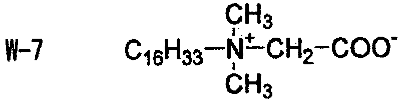

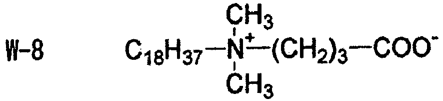

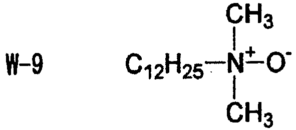

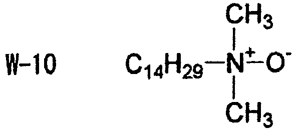

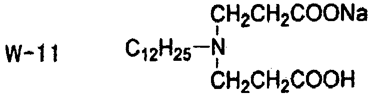

The compounds represented by the formula (A) to the formula (C) may be used alone or as a mixture of two or more kinds.

Although some compounds are overlapped with the compounds listed above, other examples of the amphoteric surfactant may include amine oxide surfactants such as alkyl dimethylamine oxides; betaine surfactants such as alkyl betaines, fatty acid amide propyl betaines, and alkyl imidazole; and amino acid surfactants such as alkylamino fatty acid sodium, and these surfactants may also be used for the treatment liquid in the present invention.

In particular, alkyl dimethylamine oxides, which may have a substituent, alkyl carboxybetaines, which may have a substituent, and alkyl sulfobetaines, which may have a substituent, are preferably used. Specific examples thereof may include compounds represented by the formula (2) in paragraph [0256] of JP-A No. 2008-203359; compounds represented by the formula (I), (II) or (VI) in paragraph [0028] of JP-A No. 2008-276166; and compounds described in paragraphs [0022] to [0029] of JP-A No. 2009-47927.

Examples of the compounds represented by the formula (A) to the formula (C) may further include the following compounds, but the present invention is not limited thereto.

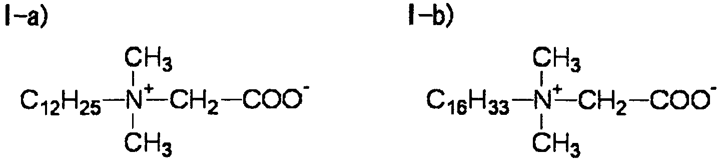

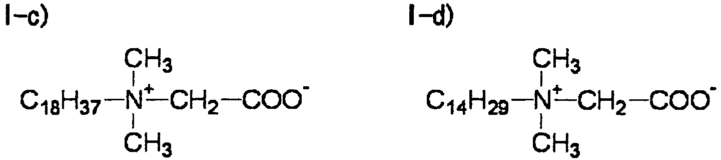

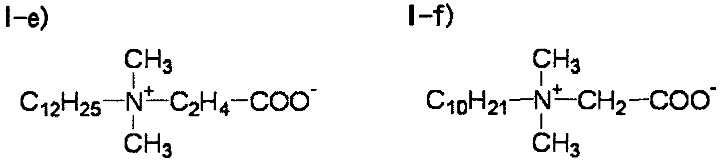

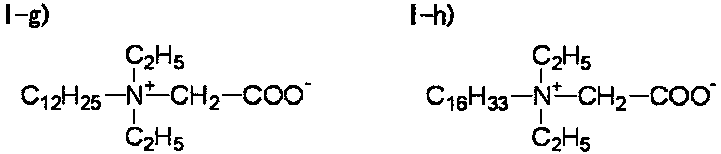

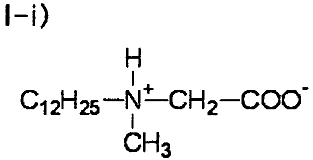

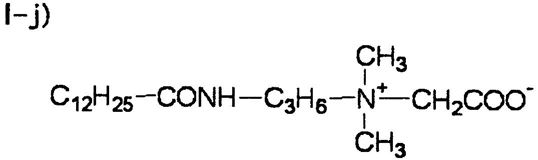

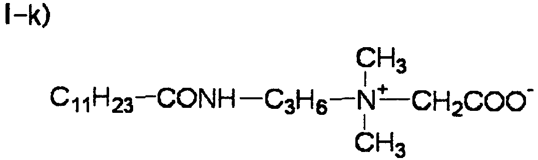

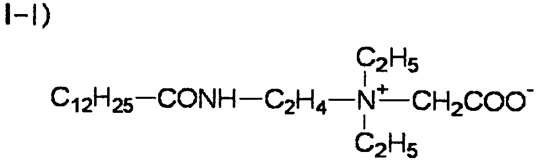

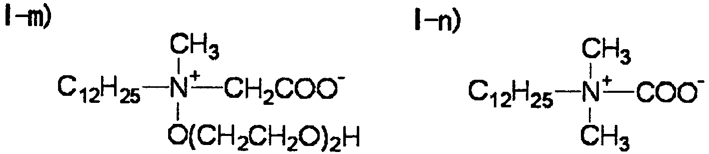

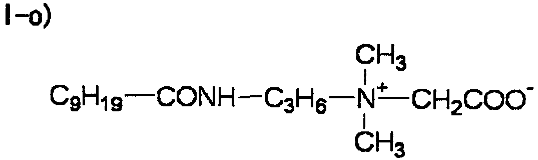

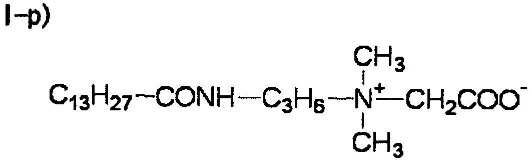

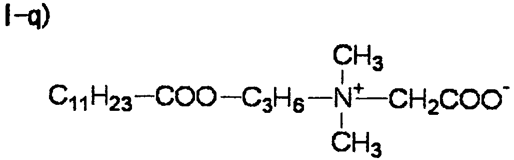

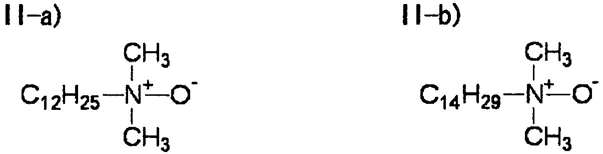

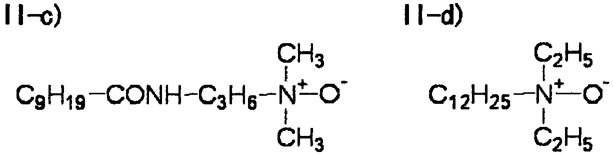

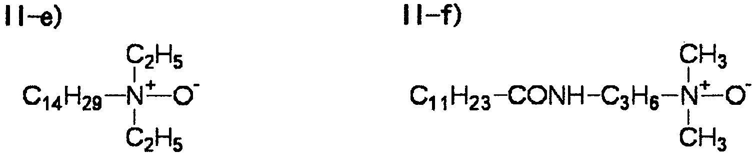

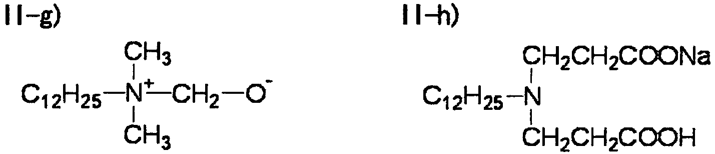

The compounds represented by the formula (A) to the formula (C) can be synthesized according to a known method. Commercially available products may also be used. The commercially available products may include SOFTAZOLINE LPB, SOFTAZOLINE LPB-R and VISTA MAP, which are manufactured by Kawaken Fine Chemicals Co., Ltd., and TAKESAAF C-157L manufactured by Takemoto Oil & Fat Co., Ltd., for the compound represented by the formula (A); and SOFTAZOLINE LAO manufactured by Kawaken Fine Chemicals Co., Ltd, and AMOGEN AOL manufactured by DAI-ICHI Kogyo Seiyaku Co., Ltd., for the compound represented by the formula (B).

The amphoteric surfactant is described in detail in JP-A No. H4-13149 and JP-A No. S59-121044, and the descriptions thereof can be referred.

The amphoteric surfactants may be used alone or as a mixture of two or more kinds in the developer.

### (Anionic Surfactant)

The anionic surfactant, which is another preferable example of the surfactant used in the treatment liquid in the present invention, will be explained. Examples of the anionic surfactant used in the treatment liquid may include at least one compound represented by any one of the following formula (D) to formula (G).

R⁶-L²-D¹ Formula (D)

R⁷-L³-E¹ Formula (E)

R⁸-L⁴-F¹ Formula (F)

R⁹-L⁵-O-L⁶-G¹ Formula (G)

In the formula (D) to the formula (G), R⁶ and R⁹ each independently represent an alkyl group having 6 to 24 carbon atoms; L² represents a single bond or a phenylene group; D¹, E¹, F¹ and G¹ each independently represent a sulfonic acid group or a salt thereof, or a sulfuric acid group or a salt thereof; R⁷ represents an alkyl group having 4 to 18 carbon atoms; L³ represents a phenylene group or a naphthylene group; R⁸ represents a phenyl group or a naphthyl group; L⁴ represents a polyalkyleneoxy group; and L⁵ and L⁶ each independently represent a phenylene group.

More specifically, examples of the anionic surfactants may include fatty acid salts, abietic acid salts, hydroxyalkane sulfonic acid salts, alkane sulfonic acid salts, dialkylsulfosuccinic acid salts, linear alkylbenzene sulfonic acid salts, branched alkylbenzene sulfonic acid salts, alkylnaphthalene sulfonic acid salts, alkylphenoxypolyoxyethylene propyl sulfonic acid salts, polyoxyethylene alkylsulfophenyl ether salts, N-methyl-N-oleyltaurine sodium salts, N-alkylsulfosuccinic acid monoamide disodium salts, petroleum sulfonic acid salts, sulfated castor oil, sulfated beef tallow oil, sulfate ester salts of fatty acid alkyl esters, alkyl sulfate ester salts, polyoxyethylene alkyl ether sulfate ester salts, fatty acid monoglyceride sulfate ester salts, polyoxyethylene alkylphenyl ether sulfate ester salts, polyoxyethylene styrylphenyl ether sulfate ester salts, alkylphosphate ester salts, polyoxyethylene alkyl ether phosphate ester salts, polyoxyethylene alkylphenyl ether phosphate ester salts, partially saponified products of styrene-maleic anhydride copolymers, partially saponified products of olefin-maleic anhydride copolymers, naphthalenesulfonic acid salt-formalin condensates, aromatic sulfonic acid salts, and aromatic substituted polyoxyethylene sulfonic acid salts. Of these, dialkylsulfosuccinic acid salts, alkylsulfate ester salts, and alkylnaphthalenesulfonic acid salts are particularly preferably used.

As the anionic surfactant used in the treatment liquid in the present invention, an anionic surfactant including a sulfonic acid or a sulfonic acid salt is particularly preferable. The anionic surfactants may be used alone or as a mixture.

Of the surfactants described above, betaine amphoteric surfactants are preferable in terms of the improvement of the printing durability of the image area on the obtained planographic printing plate.

A content ratio of the surfactant in the treatment liquid is preferably from 0.2% by mass to 20% by mass, more preferably from 0.3% by mass to 10% by mass. When the surfactant content ratio is adjusted to the range described above, the good developability can be attained, the printing durability of the image area is not reduced, and the obtained planographic printing plate has an image area having high scratch resistance.

### (pH-Controlling Agent)

An alkali agent is used for maintaining the pH of the treatment liquid to 7 to 12, and in the treatment liquid in the present invention, it is preferable to use a buffer.

The existence of carbonate ions and hydrogen carbonate ions as the buffer can inhibit the change of pH even if the treatment liquid is used over a long term, and thus can inhibit reduction of the developability and generation of development scum, which are caused by the change of pH.

In order to make the carbonate ions and hydrogen carbonate ions exist in the developer, a carbonate salt and a hydrogen carbonate salt may be added to the treatment liquid, or a carbonate salt or a hydrogen carbonate salt may be added and then the pH may be adjusted, whereby the carbonate ions and the hydrogen carbonate ions may be generated. The carbonate salt and the hydrogen carbonate salt are not particularly limited, but alkali metal salts are preferable. Examples of the alkali metals may include lithium, sodium, and potassium, and sodium is particularly preferable. They may be used alone or as a mixture of two or more kinds.

It is necessary that the treatment liquid in the present invention has a pH of 7 to 12 as described above, and the more preferable range of the pH is from 8 to 11. The buffer, accordingly, is used in conditions in which the pH is adjusted to the range described above.

A total amount of the carbonate salt and the hydrogen carbonate salt is preferably from 0.3% by mass to 20% by mass, more preferably from 0.5% by mass to 10% by mass, and particularly preferably from 1% by mass to 5% by mass, with respect to the total weight of the developer. When the total amount is 0.3% by mass or more, the developability and the treatment ability are not reduced, and when it is 20% by mass or less, generation of precipitation or crystals is unlikely to occur, and gelation is unlikely to occur during neutralization in liquid-waste disposal of the developer, so that the liquid-waste disposal is not hindered.

The developer may include, in addition to the components described above, a wetting agent, a preservative, a chelate compound, an antifoaming agent, an organic acid, an organic solvent, an inorganic acid, and an inorganic salt.

The additives which can optionally be included in the treatment liquid will be explained below.

As the preservative, phenol and its derivatives, formalin, imidazole derivatives, sodium dehydroacetate, 4-isothiazolin-3-one derivatives, benzoisothiazolin-3-one, 2-methyl-4-isothiazolin-3-one, benztriazole derivatives, amidine guanidine derivatives, quaternary ammonium salts, derivatives of pyridine, quinoline or guanidine, diazine, triazole derivatives, oxazole, oxazine derivatives, nitrobromoalcohol-type 2-bromo-2-nitropropane-1,3-diol, 1,1 -dibromo-1-nitro-2-ethanol, and 1,1-dibromo-1-nitro-2-propanol are preferably used. Commercially available preservatives may be used, and examples thereof may include BIOHOPE (K·I Chemical Industry Co., Ltd.).

An amount of the preservative added is an amount in which an effect can be stably exhibited against bacteria, molds, yeast, and the like. The amount depends on the kind of the bacteria, the mold or the yeast, but it is preferably within a range of 0.01 to 4% by mass with respect to the treatment liquid in use, and it is preferable to use two or more kinds of the preservatives at the same time for exhibiting the effect to various molds or sterilization.

Examples of the chelate compounds may include, for example, ethylene diamine tetraacetic acid, and a potassium salt and a sodium salt thereof; diethylene triamine pentaacetic acid, and a potassium salt and a sodium salt thereof; triethylene tetramine hexaacetic acid, and a potassium salt and a sodium salt thereof; hydroxyethylethylene diamine triacetic acid, and a potassium salt and a sodium salt thereof; nitrilotriacetic acid, and a sodium salt thereof; and organic phosphonic acids and phosphonoalkane tricarboxylic acids including 1-hydroxyethane-1,1-diphosphonic acid, and a potassium salt and a sodium salt thereof, and aminotri(methylenephosphonic acid), and a potassium salt and a sodium salt thereof. As the chelate agents described above, organic amine salts are also effective instead of the sodium salts or potassium salts. Commercially available chelate agents may also be used, and examples thereof may include OCTAQUEST E30 (InnoSpec Specialty Chemicals Inc.), and DQ-2066 (Thermphos International).

Chelate agents which stably exist in the treatment liquid composition and do not inhibit the printability are selected. An addition amount is preferably from 0.001 to 1.0% by mass with respect to the treatment liquid in use.

As the antifoaming agent, a compound such as general silicone self-emulsification type, emulsification type, or a nonionic surfactant having an HLB of 5 or less may be used. Silicone antifoaming agents are preferable, and any of emulsification dispersion type and solubilization type thereof may be used. Commercially available antifoaming agents may be used, and example thereof may include TSA 739 (Tanak Co., Ltd.), and OLFIN AK-02 (Nissin Chemical Co., Ltd.).

A content of the antifoaming agent is preferably within a range of 0.001 to 1.0% by mass with respect to the treatment liquid in use.

Examples of the inorganic acids and inorganic salts may include phosphoric acid, metaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate. A content of the inorganic salt is preferably from 0.01 to 0.5% by mass based on the total mass of the treatment liquid.

A development temperature is not particularly limited so long as the development can be performed, and it is preferably 60°C or lower, more preferably from 15°C to 40°C. In a development treatment using an automatic developing machine, a developer may fatigue depending on the treatment amount, and thus the treatment ability thereof may be recovered by using a replenishing liquid or a fresh developer. One example of a development treatment and a post-treatment thereof may include a method in which an alkali development is performed, the alkali is removed in a post-water washing step, a gumming treatment is performed in a gumming step, and the resulting product is dried in a drying step. Another example may preferably include a method in which pre-water washing, development and gumming are performed at the same time using an aqueous solution including the carbonate ions, hydrogen carbonate ions and surfactants. Thus, the pre-water washing step may not be necessarily performed, and it is preferable that the pre-water washing, the development and the gumming are performed in one bath using only one liquid, and then the drying step is performed. It is preferable that after the development, excessive developer is removed using a squeeze roller, or the like, and the drying is performed.

After the development step, preferably, the drying step is provided continuously or discontinuously. The drying is performed using hot air, infrared radiation, far infrared radiation, or the like.

As the automatic treating machine, which is preferably used in the method for producing the planographic printing plate of the present invention, a device having a developing section and a drying section is used, wherein the planographic printing plate precursor is subjected to the development and the gumming in the developing tank, and after that it is dried in the drying section to obtain a planographic printing plate.

In order to improve the printing durability, and the like, a printing plate after the development can be heated in very strong conditions. The heating temperature is usually within a range of 200°C to 500°C. When the temperature is low, a sufficient image-strengthening effect cannot be obtained, and when the temperature is too high, problems such as the deteriorated support or the thermal decomposition of the image area may occur.

The thus obtained planographic printing plate is applied to an offset printing machine and is preferably used for many sheet printing.

### EXAMPLES

The present invention will be explained in accordance with Examples, but the invention is not limited to these Examples. "Part" means "part by mass" and "%" means "% by mass", unless otherwise indicated.

### (Example 1)

### <Production of Support>

A surface of a JIS A 1050 aluminum plate having a thickness of 0.3 mm was subjected to graining with a rolling nylon brush using a pumice-water suspension as an abrasive. At this time, a surface roughness (center line average roughness) was 0.5 µm. After it was washed with water, the resulting plate was immersed in a 10% aqueous sodium hydroxide solution warmed to 70°C, and etching was performed so that an amount of the aluminum dissolved was 6 g/m³. After it was washed with water, the etched plate was immersed in a 30% aqueous nitric acid solution for one minute to neutralize it, and it was thoroughly washed with water.

After that, the resulting plate was subjected to electrolytic surface-roughening for 20 seconds using a rectangular wave alternating wave voltage with a voltage at anode of 13 V and a voltage at cathode of 6 V in a 0.7% aqueous nitric acid solution, and the surface thereof was washed by immersing it in a 20% sulfuric acid solution having a temperature of 50°C, followed by washing with water. The surface-roughened aluminum plate was subjected to a porous anodic oxidation film-forming treatment using direct current in a 20% aqueous sulfuric acid solution. Electrolysis was performed at a current density of 5 A/dm², wherein an electrolysis times was adjusted, whereby a substrate having an anodic oxidation film with a mass of 4.0 g/m² on its surface was produced. This substrate was treated in a steam chamber saturated at 100°C under 1 atm for 10 seconds, whereby a substrate (b) having a sealing rate of 60% was produced. The substrate (b) was subjected to a surface hydrophilization by treating it with an aqueous solution including 2.5% by mass of sodium silicate at 30°C for 10 seconds, which was defined as support [A].

### <Formation of Intermediate Layer>

The surface of the obtained support [A] was coated with a coating liquid 1 for the intermediate layer having the following prescription, and the coating film was dried at 80°C for 15 seconds, whereby an intermediate layer was formed on the surface of the support [A] for a planographic printing plate. The coating amount of the intermediate layer after drying was 15 mg/m².

-Coating Liquid 1 for Intermediate Layer-
- Specific polymer (P-1: Polymer listed above) 0.5g
- Methanol 100g
- Water 1g

### <Formation of Lower Layer>

The support having the intermediate layer obtained as above was coated with a coating liquid 1 for a lower layer having the following composition using a bar coater so as to have a coating amount of 1.5 g/m², and then the film was dried at 160°C for 44 seconds. Immediately, the plate was cooled with a cold blast having a temperature of 17 to 20°C until the temperature of the support was 35°C.

### -Coating Liquid 1 for Lower Layer-

- N-phenylmaleimide/methacrylic acid/methacrylamide copolymer (mass ratio: 59/15/25, Mw: 50,000) [(B) Water-insoluble and alkali-soluble polymer] 5.21g
- Cyanine dye A [(A) infrared absorber having the following structure] 0.94 g
- Crystal violet (manufactured by Hodogaya Chemical Co., Ltd.) 0.08 g
- m-/p-Cresol novolac resin (m/p=6/4, Mw=3500) [(B) Component] 1.04 g
- Methyl ethyl ketone 61.00 g
- Propylene glycol monomethyl ether 14.00 g
- γ-Butyrolactone 9.40 g
- Water 0.03 g

### <Formation of Upper Layer>

After that, a coating liquid 1 for an upper layer having the following composition was coated in a coating amount of 0.5 g/m² using a bar coater, and then the film was dried at 130°C for 40 seconds and gradually cooled using blast having a temperature of 20 to 26°C, whereby a planographic printing plate precursor of Example 1 was produced.

### -Coating Liquid 1 for Upper Layer-

- Polyurethane (1) [(B-2) Component] (25%, 3-Pentanone solution) 24.00 g
- Cyanine dye A [(A) Component having the following structure] 0.15 g
- Ethyl violet 0.03 g
- Fluorine-containing surfactant: MEGAFACE F-176 (manufactured by DIC Corporation) 0.05 g
- m-/p-Cresol novolac resin [(B) Component] (m/p=6/4, Mw=3500) 1.50 g
- 3-Pentanone 62.40 g
- Propylene glycol monomethyl ether-2-acetate 7.37 g

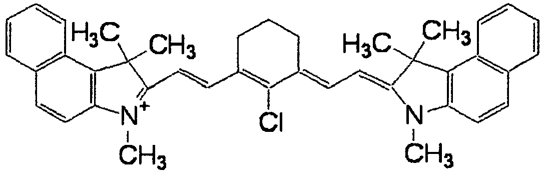

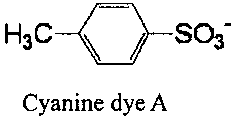

### <Polyurethane (1)>

To a 500 ml round-bottom three-necked flask equipped with a concentrator and a stirrer were added 2.7 g of 4,4'-diphenylmethane diisocyanate, 14.5 g of toluene-2,4-diisocyanate, 7.0 g of neopentyl glycol, 35.8 g of 2,2-bis(hydroxymethyl)propionic acid, and 280 g of 3-pentanone.

To the mixture was added 0.3 g of dibutyltin didodecanoate, and the reaction mixture was heated to 80°C while it was stirred. The reaction was continued at 80°C for 6 hours. The water-insoluble and alkali-soluble polyurethane (polyurethane (1)) used in the upper layer was obtained as above. A weight average molecular weight thereof was 24000 in accordance with GPC, and an acid value was 125.

### (Examples 2 to 7 and Comparative Examples 1 to 4)

An intermediate layer and an image-forming layer were formed in the same manner as in Example 1, except that the specific polymer (P-2), (P-3), (P-4), (P-5), (P-6) or (P-7) listed above was used instead of the specific polymer (P-1) used in the coating liquid 1 for the intermediate layer 1, whereby a planographic printing plate precursor of each of Example 2 to Example 7 was obtained.

In addition, an intermediate layer and an image-forming layer were formed in the same manner as in Example 1, except that a comparative polymer (PN-1), (PN-2), (PN-3) or (PN-4) shown below was used instead of the specific polymer (P-1) used in the coating liquid 1 for the intermediate layer, whereby a planographic printing plate precursor of each of Comparative Example 1 to Comparative Example 4 was obtained.

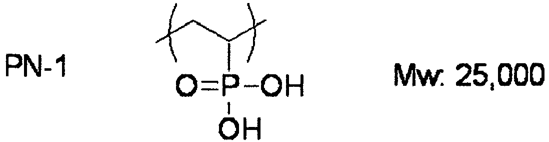

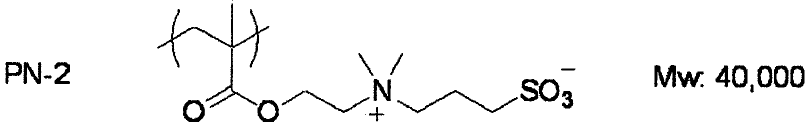

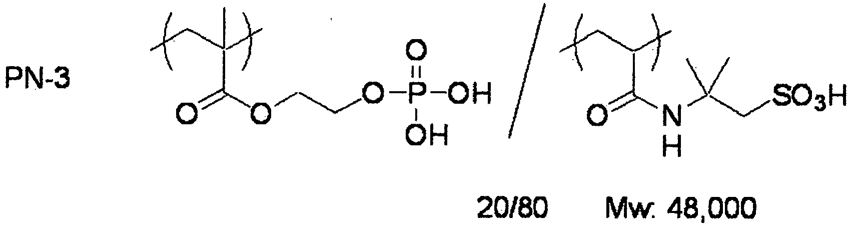

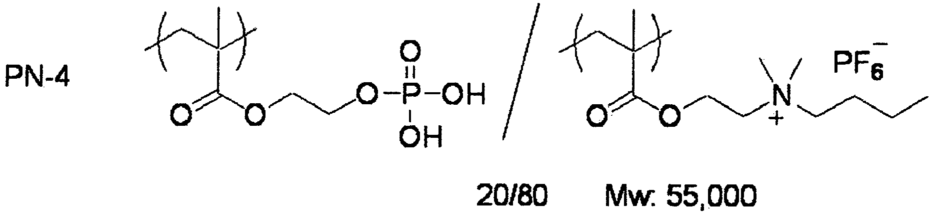

### (Plate Making and Evaluations of Planographic Printing Plate Precursor)

Using the obtained planographic printing plate precursor of Examples 1 to 7 and the planographic printing plate precursor of Comparative Examples 1 to 4, the plate-making treatment was performed in accordance with the exposure step and the development step of the production method of the present invention, and then, each evaluation described below was performed. The exposure step, the development step, and the evaluation method applied to each evaluation are described in detail below. The evaluation results are shown in Table 1.

### (Evaluation of Planographic Printing Plate Precursor)

### 1. Evaluation of Printing durability

A test pattern was image-wise drawn on each of the obtained planographic printing plate precursors using TRENDSETTER (trade name) manufactured by Creo Co., Ltd. at a beam intensity of 9 W at a drum revolving speed of 150 rpm.

After that, development was performed using a PS processor LP 940 H2, manufactured by FUJIFILM Corporation, including treatment liquid shown in Table 1 or Table 2, which had a prescription [(D-1) or (D-2)] shown below, at a development temperature of 30°C for a development time of 12 seconds. A 1:1 diluted XP-G, manufactured by FUJIFILM Corporation, was used as finisher-gum.

The produced planographic printing plate was applied to a printer RITHRONE (trade name) manufactured by KOMORI Corporation, and printing was performed continuously using an ink of NEX SUMI YZ manufactured by Toyo Ink Co., Ltd., and a dampening water of IF 102 (4%) manufactured by FUJIFILM Corporation. At that time, printing durability was evaluated by visually observing how many sheets having sufficient ink density were printed.

The printing durability was evaluated based on the following criteria using a relative value based on a value in Example 1 being 1.0.
A: 0.9 or more
B: 0.8 or more but less than 0.9
C: Less than 0.8

### 2. Evaluation of Stain Resistance in Non-Image Area

A test pattern was image-wise drawn on each of the obtained planographic printing plate precursors using TRENDSETTER (trade name) manufactured by Creo Co., Ltd. at a beam intensity of 9 W at a drum revolving speed of 150 rpm.

After that, development was performed using a PS processor LP 940 H2, manufactured by FUJIFILM Corporation, including treatment liquid shown in Table 1 or Table 2, which had a prescription [(D-1) or (D-2)] shown below, at a development temperature of 30°C for a development time of 12 seconds. A 1:1 diluted XP-G, manufactured by FUJIFILM Corporation, was used as finisher-gum.

The obtained planographic printing plate was applied to OLIVER 66 EZ (trade name) manufactured by Sakurai Graphic Systems Corp., and printing was performed continuously using an ink of FUSION G EZ (S) BENI, manufactured by DIC Corporation, and a dampening water of IF 102 (4%) manufactured by FUJIFILM Corporation. After the printer was stopped once when a thousand sheets of paper were printed, the printer was allowed to stand for one hour, and then the printing was restarted and 200 sheets of paper were printed. The number of sheets of paper until the ink completely disappeared from the non-image area was determined. The evaluation was made such that the smaller number of sheets indicated that the non-image area had better hydrophilicity and little stain, and the number of maculature from the start of printing was small, and thus the stain resistance was better.

### <Treatment Liquid D-1: Product in Present Invention>

| | |
|---|---|
| Water | 800 g |
| Sodium carbonate [buffer] | 10.6 g |
| Sodium hydrogen carbonate [buffer] | 5.2 g |
| PIONIN C158G (Takemoto Oil & Fat Co., Ltd.) | 200 g |
| [an amphoteric surfactant represented by the formula (C)] | |
| OCTAQUEST E30 (InnoSpec Specialty Chemicals Inc.) | 6.8g |
| TSA739 (TANAC Co., Ltd.) | 0.5 g |
| BIOHOPE (K·I Chemical Industry Co., Ltd.) | 1.5 g |
| (pH of the treatment liquid: 9.9) | |

### <Treatment Liquid D-2: Product in Present Invention>

The treatment liquid D-2 was prepared in the same manner as in the preparation of treatment liquid D-1 except that 50 g of NEWCOL B4SN (an anionic surfactant manufactured by Nippon Nyukazai Co., Ltd.) and 150 g of water were added instead of 200 g of the surfactant, PIONIN C158G (manufactured by Takemoto Oil & Fat Co., Ltd.) used in the treatment liquid D-1.

### (pH of the treatment liquid: 9.9)

### <Treatment Liquid D-3: Product in Present Invention>

Treatment liquid D-3 was prepared in the same manner as the preparation of the treatment liquid D-1 except that 30 g of SOFTAZOLINE LAO (manufactured by Kawaken Fine Chemicals Co., Ltd) and 100 g of water were added instead of 200 g of the surfactant, PIONIN C158G (manufactured by manufactured by Takemoto Oil & Fat Co., Ltd.) used in the treatment liquid D-1.

### (pH of the treatment liquid: 9.9)

### <Developer D-4: Comparative Product>

| | |
|---|---|
| Water | 691 g |
| Sorbitol | 67.7 g |
| KOH (48%) | 27.5 g |
| Tripotassium citrate monohydrate | 13.2g |
| DQ-2066 (Thermphos International) | 0.4 g |
| PIONIN C158G (Takemoto Oil & Fat Co., Ltd.) | 200 g |
| [The amphoteric surfactant represented by the formula (C)] | |
| OLFINE AK-02 (Nisshin Chemical Co., Ltd.) | 0.3 g |
| (pH of the treatment liquid: 13.2) | |

### (Example 8, Example 9 and Reference Example 10)

Using the planographic printing plate precursor according to the present invention obtained in Example 2, a planographic printing plate was produced in the same manner as in Example 2 except that the treatment liquid (D-2), (D-3) or (D-4) was used instead of the treatment liquid (D-1), and evaluations were performed in the same manner as in Example 2. The results are shown in Table 2.

### (Examples 11 and 12, and Comparative Examples 5 and 6)

A planographic printing plate precursor was made in the same manner as in Example 2 except that the coating amount of the intermediate layer, in the planographic printing plate precursor obtained in Example 2, was changed to the amount in Table 2, and the evaluations were performed in the same manner as in Example 2. The results are shown in Table 2.

**Table 1**

| | Intermediate Layer | | | Evaluation results | |
|---|---|---|---|---|---|
| | Specific polymer or comparative polymer | Coating amount (mg/m²) | Treatment liquid | Printing durability | Stain resistance |
| Example 1 | P-1 | 15 | D-1 | A | 20 |
| Example 2 | P-2 | 15 | D-1 | A | 20 |
| Example 3 | P-3 | 15 | D-1 | A | 20 |
| Example 4 | P-4 | 15 | D-1 | A | 20 |
| Example 5 | P-5 | 15 | D-1 | A | 20 |
| Example 6 | P-6 | 15 | D-1 | B | 40 |
| Example 7 | P-7 | 15 | D-1 | A | 40 |
| Comparative Example 1 | PN-1 | 15 | D-1 | C | 40 |
| Comparative Example 2 | PN-2 | 15 | D-1 | C | 200 |
| Comparative Example 3 | PN-3 | 15 | D-1 | C | 20 |
| Comparative Example 4 | PN-4 | 15 | D-1 | A | 200 |

From the results in Table 1, it can be seen that the planographic printing plate precursor of Examples 1 to 7 according to the present invention have the higher printing durability in the image area and the better stain resistance in the non-image area than those of the planographic printing plate precursors of Comparative Examples 1 to 4.

It can also been seen from the comparison of Example 2 with Examples 6 and 7 that in the case of the specific polymer having the same repeating units, the effects can be particularly remarkably exhibited in the preferable ratio range of the repeating unit represented by the formula (1-1) to the repeating unit represented by the formula (I-2) of from 10:90 to 40:60.

**Table 2**

| | Intermediate Layer | | | Evaluation results | |
|---|---|---|---|---|---|
| | Specific polymer or comparative polymer | Coating amount (mg/m²) | Treatment liquid | Printing durability | Stain resistance |
| Example 8 | P-2 | 15 | D-2 | B | 20 |
| Example 9 | P-2 | 15 | D-3 | A | 20 |
| Reference Example 10 | P-2 | 15 | D-4 | A | 40 |
| Example 11 | P-2 | 3 | D-1 | A | 40 |
| Example 12 | P-2 | 150 | D-1 | B | 20 |
| Comparative Example 5 | P-2 | 1 | D-1 | A | 150 |
| Comparative Example 6 | P-2 | 250 | D-1 | C | 20 |

From the comparison of Example 2, with Example 8, Example 9 and Reference Example 10 in Table 1 and Table 2 above, it can be seen that Example 2 wherein the development is performed using the treatment liquid with a pH of 7 to 12 according to the production method of the present invention, has the better stain resistance than that of the planographic printing plate of Reference Example 10 wherein the development is performed using the treatment liquid with a higher pH, and that in the case in which the treatment liquid including the amphoteric surfactant, which is preferable as the surfactant, the resulting printing durability is more improved than the case of the treatment liquid using the anionic surfactant.

Furthermore, from the results of Table 2, it can be seen that even if the coating amount of the intermediate layer is changed, the effects of the present invention are exhibited, and when the coating amount is outside the range of the present invention, it is difficult to satisfy both the printing durability and the stain resistance.

## Claims

1. A method for producing a planographic printing plate, comprising the steps of:
image-wise exposing a positive type planographic printing plate precursor including an intermediate layer and a positive type image-forming layer successively on a support, the intermediate layer having a coating amount after drying of from 2 mg/m² to 200 mg/m² and including a polymer including a repeating unit represented by the following formula (I-1) and a repeating unit represented by the following formula (I-2); and
developing the exposed positive type planographic printing plate precursor by removing image-wise exposed areas using a treatment liquid having a pH of from 7 to 12: 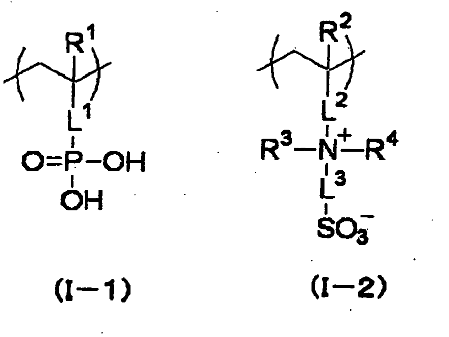 wherein, in the formula (I-1), R¹ represents a hydrogen atom, a methyl group, or an ethyl group; L¹ represents a single bond or -COO-(CH₂CH₂O)ₙ-; and n represents an integer of from 1 to 12, and wherein, in the formula (I-2), R² represents a hydrogen atom, a methyl group, or an ethyl group; R³ and R⁴ each independently represent an alkyl group having 1 to 3 carbon atoms; L² represents a linking group selected from -COO-, -CONH-, or an alkylene group having 1 to 5 carbon atoms, or a linking group formed by connecting two or more of these; and L³ represents an alkylene group or -CH₂CHOHCH₂-.

2. The method for producing a planographic printing plate according to claim 1, wherein a molar content ratio of the repeating unit represented by the formula (I-1) to the repeating unit represented by the formula (I-2) in the polymer is in a range of from 5:95 to 50:50.

3. The method for producing a planographic printing plate according to claim 1 or 2, wherein the polymer further includes one or more repeating units each having a hydrophilic group and differing in structure from the repeating unit represented by the formula (I-1) and the repeating unit represented by the formula (1-2).

4. The method for producing a planographic printing plate according to any one of claims 1-3, wherein the positive type image-forming layer includes a water-insoluble and alkali-soluble polymer and an infrared absorber.

5. The method for producing a planographic printing plate according to any one of claims 1-4, wherein the treatment liquid is a buffer solution.

6. The method for producing a planographic printing plate according to any one of claims 1-5, wherein the treatment liquid includes a surfactant.

7. The method for producing a planographic printing plate according to claim 6, wherein a content ratio of the surfactant in the treatment liquid is from 0.2% by mass to 20% by mass.

8. The method for producing a planographic printing plate according to claim 6 or 7, wherein the surfactant is a betaine surfactant.

9. A planographic printing plate which is obtainable by the production method according to any one of claims 1-8.

## Patentansprüche

1. Verfahren zur Herstellung einer Flachdruckplatte, umfassend die Schritte:
bildweises Belichten eines Positiv-Flachdruckplattenvorläufers, der eine Zwischenschicht und eine Positiv-Bilderzeugungsschicht nacheinander auf einem Träger einschliesst, wobei die Zwischenschicht nach dem Trocknen eine Beschichtungsmenge von 2 bis 200 mg/m² aufweist und ein Polymer einschliesst, das eine Wiederholungseinheit der nachstehenden Formel (I-1) und eine Wiederholungseinheit der nachstehenden Formel (1-2) einschliesst; und
Entwickeln des belichteten Positiv-Flachdruckplattenvorläufers durch Entfernen der bildweise belichteten Bereiche unter Verwendung einer Behandlungsflüssigkeit mit einem pH-Wert von 7 bis 12: 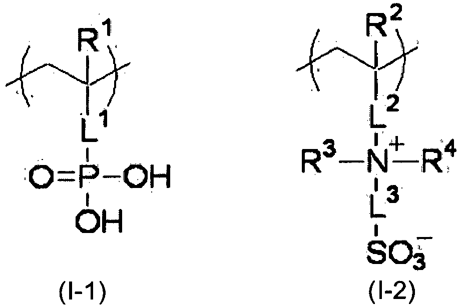 wobei in der Formel (1-1) R¹ ein Wasserstoffatom, eine Methylgruppe oder eine Ethylgruppe darstellt; L¹ eine Einfachbindung oder -COO-(CH₂CH₂O)ₙ- darstellt und n eine ganze Zahl von 1 bis 12 darstellt, und wobei in der Formel (1-2) R² ein Wasserstoffatom, eine Methylgruppe oder eine Ethylgruppe darstellt; R³ und R⁴ jeweils unabhängig eine Alkylgruppe mit 1 bis 3 Kohlenstoffatom(en) darstellen; L² eine Verknüpfungsgruppe, ausgewählt aus -COO-, -CONH- oder einer Alkylengruppe mit 1 bis 5 Kohlenstoffatom(en), oder eine Verknüpfungsgruppe, die durch Verbinden von zwei oder mehreren davon gebildet ist, darstellt und L³ eine Alkylengruppe oder -CH₂CHOHCH₂- darstellt.

2. Verfahren zur Herstellung einer Flachdruckplatte gemäss Anspruch 1, wobei das molare Verhältnis des Gehalts an Wiederholungseinheit der Formel (I-1) zu Wiederholungseinheit der Formel (1-2) in dem Polymer im Bereich von 5:95 bis 50:50 liegt.

3. Verfahren zur Herstellung einer Flachdruckplatte gemäss Anspruch 1 oder 2, wobei das Polymer ferner eine oder mehrere Wiederholungseinheit(en) einschliesst, von denen jede eine hydrophile Gruppe aufweist und sich in der Struktur von der Wiederholungseinheit der Formel (I-1) und der Wiederholungseinheit der Formel (1-2) unterscheidet.

4. Verfahren zur Herstellung einer Flachdruckplatte gemäss irgendeinem der Ansprüche 1 bis 3, wobei die Positiv-Bilderzeugungsschicht ein wasserunlösliches und alkalilösliches Polymer und einen Infrarotabsorber einschliesst.

5. Verfahren zur Herstellung einer Flachdruckplatte gemäss irgendeinem der Ansprüche 1 bis 4, wobei die Behandlungsflüssigkeit eine Pufferlösung ist.

6. Verfahren zur Herstellung einer Flachdruckplatte gemäss irgendeinem der Ansprüche 1 bis 5, wobei die Behandlungsflüssigkeit ein Tensid einschliesst.

7. Verfahren zur Herstellung einer Flachdruckplatte gemäss Anspruch 6, wobei das Verhältnis des Gehalts an Tensid in der Behandlungsflüssigkeit 0,2 bis 20 Masse-% beträgt.

8. Verfahren zur Herstellung einer Flachdruckplatte gemäss Anspruch 6 oder 7, wobei das Tensid ein Betain-Tensid ist.

9. Flachdruckplatte, die durch das Herstellungsverfahren gemäss irgendeinem der Ansprüche 1 bis 8 erhältlich ist.

## Revendications

1. Procédé de fabrication d'une plaque d'impression planographique, comprenant les étapes consistant à :
exposer selon une image à un précurseur de plaque d'impression planographique de type positif comprenant une couche intermédiaire et une couche formant une image de type positif successivement sur un support, la couche intermédiaire ayant une quantité de revêtement après séchage de 2 mg/m² à 200 mg/m² et comprenant un polymère incluant un motif de répétition représenté par la formule suivante (1-1) et un motif de répétition représenté par la formule suivante (1-2) ; et
développer le précurseur de plaque d'impression planographique de type positif exposé en enlevant selon une image les zones exposées en utilisant un liquide de traitement ayant un pH de 7 à 12 : 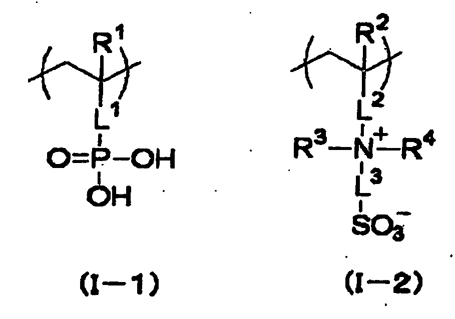 où, dans la formule (I-1), R¹ représente un atome d'hydrogène, un groupement méthyle ou un groupement éthyle ; L¹ représente une liaison simple ou un groupement -COO-(CH₂CH₂O)ₙ ; et n représente un nombre entier de 1 à 12 et où, dans la formule (I-2), R² représente un atome d'hydrogène, un groupement méthyle, ou un groupement éthyle ; R³ et R⁴ représentent, chacun indépendamment, un groupement alkyle ayant 1 à 3 atomes de carbone ; L² représente un groupement de liaison choisi parmi les groupements -COO-, -CONH-ou un groupement alkylène ayant 1 à 5 atomes de carbone ou un groupement de liaison formé en reliant deux ou plusieurs de ceux-ci ; et L³ représente un groupement alkylène ou un groupement -CH₂ CHOHCH₂-.

2. Procédé de fabrication d'une plaque d'impression planographique selon la revendication 1, où le rapport de concentration molaire du motif de répétition représenté par la formule (I-1) à celle du motif de répétition représenté par la formule (1-2) est dans une plage de 5 : 95 à 50 : 50.

3. Procédé de fabrication d'une plaque d'impression planographique selon la revendication 1 ou 2, où le polymère comprend en outre un ou plusieurs motifs de répétition ayant chacun un groupement hydrophile et se différentiant au niveau de la structure du motif de répétition représenté par la formule (I-1) et du motif de répétition représenté par la formule (1-2).

4. Procédé de fabrication d'une plaque d'impression planographique selon l'une quelconque des revendications 1 à 3, où la couche formant une image de type positif comprend un polymère insoluble dans l'eau et soluble en milieu alcalin et un agent absorbant l'infrarouge.

5. Procédé de fabrication d'une plaque d'impression planographique selon l'une quelconque des revendications 1 à 4, où le liquide de traitement est une solution tampon.

6. Procédé de fabrication d'une plaque d'impression planographique selon l'une quelconque des revendications 1 à 5, où le liquide de traitement comprend un tensioactif.

7. Procédé de fabrication d'une plaque d'impression planographique selon la revendication 6, où le rapport de concentration du tensioactif dans le liquide de traitement est de 0,2 % en masse à 20 % en masse.

8. Procédé de fabrication d'une plaque d'impression planographique selon la revendication 6 ou 7, où le tensioactif est un tensioactif de type bétaïne.

9. Plaque d'impression planographique qui peut être obtenue par le procédé de fabrication selon l'une quelconque des revendications 1 à 8.
